# EUROPÄISCHE PATENTSCHRIFT

(11) **EP 2 603 540 B1**
(45) Veröffentlichungstag und Bekanntmachung des Hinweises auf die Patenterteilung: **21.04.2021**
(21) Anmeldenummer: 11743444.9
(22) Anmeldetag: 01.08.2011
(51) Int. Cl.: C08G 61/12, H01L 51/00

(54) **POLYMERE MIT CARBAZOL-STRUKTUREINHEITEN**
POLYMERS WITH CARBAZOLE STRUCTURAL UNITS
POLYMÈRES PRÉSENTANT DES UNITÉS STRUCTURALES CARBAZOLE

(30) Priorität: 09.08.2010 DE 102010033777
(43) Veröffentlichungstag der Anmeldung: 19.06.2013
(73) Patentinhaber: Merck Patent GmbH, 64293 Darmstadt (DE)
(72) Erfinder: SCHULTE, Niels, 65779 Kelkheim (DE); HAYER, Anna, 55118 Mainz (DE); LUDEMANN, Aurélie, 60322 Frankfurt am Main (DE)
(86) Internationale Anmeldenummer: PCT/EP2011/003843
(87) Internationale Veröffentlichungsnummer: WO 2012/019724

(56) Entgegenhaltungen:
- WO-A1-2004/055129
- WO-A2-2004/072205
- WO-A2-2009/038413
- CN-A- 101 220 137
- GB-A- 2 376 469
- US-A1- 2006 046 172
- CHUNG-WEN WU ET AL: "Synthesis and Characterization of Kinked and Hyperbranched Carbazole/Fluorene-Based Copolymers", MACROMOLECULES, Bd. 39, Nr. 21, 1. Oktober 2006 (2006-10-01), Seiten 7232-7240, XP55008548, ISSN: 0024-9297, DOI: 10.1021/ma061770j

## Beschreibung

Die vorliegende Erfindung betrifft elektronische Vorrichtungen enthaltend Polymere mit Carbazol-Struktureinheiten in der Lochtransport- oder Lochinjektionsschicht.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, häufig metallisch oder anorganisch, aber auch aus organischen bzw. polymeren leitfähigen Materialien,
(3) Ladungsinjektionsschicht/en bzw. Zwischenschicht/en, beispiels-weise zum Ausgleich von Unebenheiten der Elektrode ("planarisation layer"), häufig aus einem leitfähigen, dotierten Polymer,
(4) Organische Halbleiter,
(5) evtl. weitere Ladungstransport-, Ladungsinjektions- bzw. Ladungsblockierschichten,
(6) Gegenelektrode, Materialien wie unter (2) genannt,
(7) Verkapselung.

Die obige Anordnung stellt den allgemeinen Aufbau einer organischen, elektronischen Vorrichtung dar, wobei verschiedene Schichten zusammengefasst werden können, so dass im einfachsten Fall eine Anordnung aus zwei Elektroden resultiert, zwischen denen sich eine organische Schicht befindet. Die organische Schicht erfüllt in diesem Fall alle Funktionen, einschließlich der Emission von Licht im Fall von OLEDs. Ein derartiges System ist beispielsweise in der WO 90/13148 A1 auf der Basis von Poly-(p-phenylenen) beschrieben.

Ein Problem, das sich in einem derartigen "Dreischichtsystem" ergibt, ist jedoch die fehlende Steuerung der Ladungstrennung oder die fehlende Möglichkeit, die einzelnen Bestandteile in unterschiedlichen Schichten bezüglich ihrer Eigenschaften zu optimieren, wie es beispielsweise bei SMOLEDs ("small-molecule OLEDs") durch einen mehrschichtigen Aufbau einfach gelöst ist.

Eine "small molecule OLED" umfasst vielfach eine oder mehrere organische Lochinjektionsschichten, Lochtransportschichten, Emissionsschichten, Elektronentransportschichten und/oder Elektroneninjektionsschichten sowie eine Anode und eine Kathode, wobei sich das ganze System gewöhnlich auf einem Glassubstrat befindet. Der Vorteil einer solchen Mehrlagenstruktur besteht darin, dass verschiedene Funktionen der Ladungsinjektion, des Ladungstransports und der Emission in die verschiedenen Schichten aufgeteilt und somit die Eigenschaften der jeweiligen Schichten separat modifiziert werden können. Durch diese Modifikation kann die Leistungsfähigkeit der elektronischen Vorrichtungen stark verbessert werden.

Bekannte elektronische Vorrichtungen weisen ein brauchbares Eigenschaftsprofil auf. Allerdings besteht die dauerhafte Notwendigkeit die Eigenschaften dieser Vorrichtungen zu verbessern. Zu diesen Eigenschaften gehört insbesondere die Lebensdauer der elektronischen Vorrichtungen. Ein weiteres Problem stellt insbesondere die Energieeffizienz dar, mit der eine elektronische Vorrichtung die vorgegebene Aufgabe löst. Bei organischen Leuchtdioden, die sowohl auf niedermolekularen Verbindungen als auch auf Polymeren basieren können, sollte insbesondere die Lichtausbeute hoch sein, so dass zum Erreichen eines bestimmten Lichtstroms möglichst wenig elektrische Leistung aufgebracht werden muss. Weiterhin sollte auch zum Erzielen einer vorgegebenen Leuchtdichte eine möglichst geringe Spannung notwendig sein.

In der WO 2009/038413 A2 werden Polymere mit fluorengruppenhaltigen Wiederholungseinheiten offenbart. Diese Polymere können zusätzlich carbazolgruppenhaltige Wiederholungseinheiten aufweisen. Die Polymere werden als Hostmaterialien in der Licht-emittierenden Schicht von OLEDs eingesetzt.

In der WO 2004/072205 A2 und der WO 2004/055129 A1 werden carbazolgruppenhaltige Polymere offenbart, die ebenfalls als Hostmaterialien in der Licht-emittierenden Schicht von OLEDs eingesetzt werden.

In der CN 101220137 A werden hyperverzweigte pyridingruppenhaltige Polyarylene offenbart.

In Chung-Wen Wu et al.: "Synthesis and characterization of kinked and hyperbranched Carbazole/Fluorene-based polymers", Macromolecules, Bd. 39, Nr. 21, 1. Oktober 2006, Seiten 7232-7240, werden hyperverzweigte Polymere offenbart, die Fluoren- und Carbazol-Wiederholungseinheiten aufweisen und als Licht-emittierende Polymere eingesetzt werden, die blaues Licht emittieren.

In der GB 2376469 A1 werden weiß-emittierende Polyarylene offenbart, die Biscarbazolgruppen als Wiederholungeinheit aufweisen.

In der US 2006/046172 A1 werden polymere Ladungstransportmaterialien offenbart, die Biscarbazolgruppen als Wiederholungseinheit aufweisen. Die Biscarbazoleinheiten sind dabei über ihre Stickstoffatome ins Polymer eingebaut.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Weiterhin sollten die elektronischen Vorrichtungen für viele Zwecke eingesetzt oder angepasst werden können. Insbesondere sollte die Leistungsfähigkeit der elektronischen Vorrichtungen über einen breiten Temperaturbereich erhalten bleiben.

Überraschenderweise wurde gefunden, dass diese sowie weitere nicht explizit genannte Aufgaben, die jedoch aus den hierin einleitend diskutierten Zusammenhängen ohne Weiteres ableitbar oder erschließbar sind, durch elektronische Vorrichtungen enthaltend Polymere mit allen Merkmalen des Patentanspruchs 1 gelöst werden. Zweckmäßige Abwandlungen der erfindungsgemäßen elektronischen Vorrichtungen werden in den auf Anspruch 1 rückbezogenen abhängigen Ansprüchen unter Schutz gestellt.

Gegenstand der vorliegenden Erfindung ist dementsprechend eine elektronische Vorrichtung enthaltend ein Polymer, welches mindestens eine Carbazol-Struktureinheit der allgemeinen Formel (la) enthält 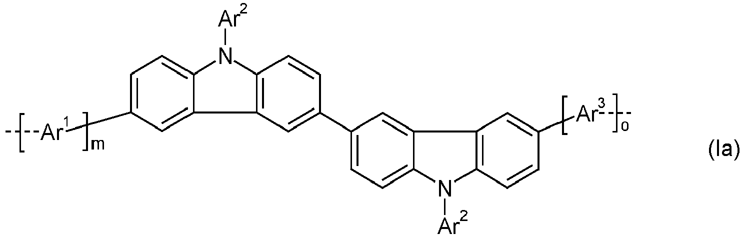 wobei
- Ar¹, Ar², Ar³: jeweils unabhängig voneinander eine Aryl- oder Heteroarylgruppe ist, welche mit einem oder mehreren beliebigen Resten R substituiert sein kann;
- m, o: unabhängig voneinander 0 oder 1 ist;
die gestrichelten Linien die Verknüpfung im Polymer darstellen;
und mindestens eine Arylamin-Struktureinheit der allgemeinen Formeln (II) und/oder (III) 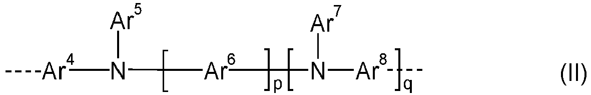 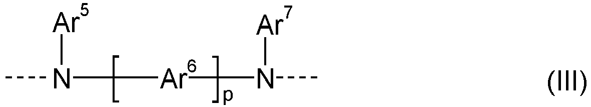 wobei
- Ar⁴, Ar⁵, Ar⁷, Ar⁸: jeweils unabhängig voneinander eine Aryl- oder Heteroarylgruppe ist, welche mit einem oder mehreren beliebigen Resten R substituiert sein kann;
- Ar⁶: eine Aryl- oder Heteroarylgruppe ist, welche mit einem oder mehreren beliebigen Resten R substituiert sein kann oder eine Gruppe der Formel Ar⁹-Y-Ar⁹ darstellt, wobei Ar⁹ jeweils unabhängig eine Aryl-oder Heteroarylgruppe ist, welche mit einem oder mehreren beliebigen Resten R substituiert ist oder welche miteinander verknüpft sein können, und Y eine Abstandsgruppe oder eine direkte Bindung ist;
- p: 1, 2 oder 3 ist;
- q: 0 oder 1 ist und die gestrichelten Linien die Verknüpfung im Polymer darstellen, dadurch gekennzeichnet, dass das Polymer in der Vorrichtung als Bestandteil der Lochtransport- oder Lochinjektionsschicht vorliegt.

In der Carbazol-Struktureinheit der allgemeinen Formel (la) sind Ar¹, Ar² und Ar³ jeweils unabhängig voneinander eine Aryl- oder Heteroarylgruppe mit 5 bis 60, vorzugsweise 5 bis 40 und besonders bevorzugt 5 bis 20 Ringatomen, welche mit einem oder mehreren beliebigen Resten R substituiert sein kann.

Die Arylamin-Struktureinheiten der allgemeinen Formeln (II) und/oder (III) umfassen die Gruppen Ar⁴, Ar⁵, Ar⁷ und Ar⁸, welche jeweils unabhängig voneinander eine Aryl- oder Heteroarylgruppe mit 5 bis 60 Ringatomen darstellen, welche mit einem oder mehreren beliebigen Resten R substituiert sein kann. In den Formeln (II) und/oder (III) bedeutet die Gruppe Ar⁶ eine Aryl- oder Heteroarylgruppe, welche mit einem oder mehreren beliebigen Resten R substituiert sein kann oder eine Gruppe der Formel Ar⁹-Y-Ar⁹, wobei Ar⁹ jeweils unabhängig eine Aryl- oder Heteroarylgruppe ist, welche mit einem oder mehreren beliebigen Resten R substituiert ist oder welche miteinander verknüpft sein können, und Y eine Abstandsgruppe oder eine direkte Bindung ist. Die Aryl- oder Heteroarylgruppe gemäß Ar⁶ und/oder Ar⁹ umfasst 5 bis 60 Ringatome. Eine Arylgruppe im Sinne der vorliegenden Erfindung enthält 6 bis 60, vorzugsweise 6 bis 40 und besonders bevorzugt 6 bis 20 C-Atome, eine Heteroarylgruppe im Sinne der vorliegenden Erfindung enthält 2 bis 59, vorzugsweise 2 bis 39 und besonders bevorzugt 2 bis 19 C-Atome und mindestens ein Heteroatom, mit der Maßgabe, dass die Summe aus C-Atomen und Heteroatomen mindestens 5 ergibt. Die Heteroatome sind vorzugsweise ausgewählt aus Si, N, P, O, S und/oder Se, wobei N, O und/oder S besonders bevorzugt sind. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin und Thiophen, oder eine kondensierte Aryl- oder Heteroarylgruppe, beispielsweise Naphthalin, Anthracen, Phenanthren, Chinolin, Isochinolin, Benzothiophen, Benzofuran und Indol, verstanden.

Besonders bevorzugt im Sinne der vorliegenden Erfindung sind die Reste Ar¹, Ar², Ar³, Ar⁴, Ar⁵, Ar⁶, Ar⁷, Ar⁸ und Ar⁹ in den Struktureinheiten der allgemeinen Formeln (la), (II) und/oder (III) jeweils unabhängig voneinander abgeleitet von Benzol, Fluoren, Spirobifluoren, cis- und trans-Indenofluoren, Naphthalin, Pyridin, Anthracen, Phenanthren, Pyrimidin, Pyrazin, Pyridazin, Chinolin, Isochinolin, Furan, Thiophen, Pyrrol, Benzofuran, Benzothiophen und Indol, wobei Benzol, Fluoren, Spirobifluoren, cis- und trans-Indenofluoren, Naphthalin, Pyridin, Anthracen, Phenanthren, Chinolin und Isochinolin ganz besonders bevorzugt sind.

In den Struktureinheiten der allgemeinen Formeln (I), (II) und/oder (III) ist es ferner bevorzugt, dass R bei jedem Auftreten unabhängig voneinander ausgewählt ist aus F, Cl, Br, I, N(Ar)₂, N(R')₂, CN, NO₂, Si(R')₃, B(OR')₂, C(=O)Ar, C(=O)R', P(=O)(Ar)₂, P(=O)(R')₂, S(=O)Ar, S(=O)R', S(=O)₂Ar, S(=O)₂R', -CR'=CR'Ar, OSO₂R', einer geradkettigen Alkyl-, Alkoxy- oder Thioalkoxygruppe mit 1 bis 40 C-Atomen, vorzugsweise 1 bis 20 C-Atomen, oder einer verzweigten oder cyclischen Alkyl-, Alkoxy- oder Thioalkoxygruppe mit 3 bis 40 C-Atomen, vorzugsweise 3 bis 20 C-Atomen, die jeweils mit einem oder mehreren Resten R' substituiert sein kann, wobei eine oder mehrere nicht benachbarte CH₂-Gruppen durch R'C=CR', C=C, Si(R')₂, Ge(R')₂, Sn(R')₂, C=O, C=S, C=Se, C=NR', P(=O)(R'), SO, SO₂, NR', O, S oder CONR' ersetzt sein können und wobei ein oder mehrere H-Atome durch F, Cl, Br, I, CN oder NO₂ ersetzt sein können, einer vernetzbaren Gruppe oder einem aromatischen oder heteroaromatischen Ringsystem mit 5 bis 60 Ringatomen, das jeweils durch einen oder mehrere Reste R' substituiert sein kann, oder einer Aryloxy- oder Heteroaryloxygruppe mit 5 bis 60 Ringatomen, die durch einen oder mehrere Reste R' substituiert sein kann, oder einer Kombination dieser Systeme, wobei zwei oder mehrere Substituenten R auch miteinander ein mono- oder polycyclisches, aliphatisches oder aromatisches Ringsystem bilden können, wobei R' jeweils unabhängig voneinander H oder ein aliphatischer oder aromatischer Kohlenwasserstoffrest mit 1 bis 20 C-Atomen und Ar eine Aryl- oder Heteroarylgruppe mit 2 bis 30 C-Atomen ist.

Die Struktureinheiten der allgemeinen Formeln (la), (II) und/oder (III) können, wie zuvor dargelegt, eine oder mehrere vernetzbare Gruppen enthalten. "Vernetzbare Gruppe" bedeutet eine funktionelle Gruppe, die in der Lage ist, irreversibel zu reagieren. Dadurch wird ein vernetztes Material gebildet, das unlöslich ist. Die Vernetzung kann gewöhnlich durch Wärme oder durch UV-, Mikrowellen-, Röntgen- oder Elektronenstrahlung unterstützt werden. Durch die hohe Stabilität des erfindungsgemäßen Polymers kommt es bei der Vernetzung zu wenig Nebenproduktbildung. Zudem vernetzen die vernetzbaren Gruppen im erfindungsgemäßen Polymer sehr leicht, so dass geringere Energiemengen für die Vernetzung erforderlich sind (z.B. < 200°C bei der thermischen Vernetzung).

Beispiele für vernetzbare Gruppen sind Einheiten, die eine Doppelbindung, eine Dreifachbindung, eine Vorstufe, die zu einer in situ Bildung einer Doppel- bzw. Dreifachbindung in der Lage ist, oder einen heterocyclischen additionspolymerisierbaren Rest enthalten. Vernetzbare Gruppen umfassen unter anderem Vinyl, Alkenyl, vorzugsweise Ethenyl und Propenyl, C₄₋₂₀-Cycloalkenyl, Azid, Oxiran, Oxetan, Di(hydrocarbyl)amino, Cyanatester, Hydroxy, Glycidylether, C₁₋₁₀-Alkylacrylat, C₁₋₁₀-Alkylmeth-acrylat, Alkenyloxy, vorzugsweise Ethenyloxy, Perfluoralkenyloxy, vorzugsweise Perfluorethenyloxy, Alkinyl, vorzugsweise Ethinyl, Maleimid, Tri(C₁₋₄)-alkylsiloxy und Tri(C₁₋₄)-alkylsilyl. Besonders bevorzugt ist Vinyl und Alkenyl.

Die Aryl- oder Heteroarylgruppen Ar⁴, Ar⁵, Ar⁶, Ar⁷ und Ar⁸ sind nicht über eine Bindung miteinander verbunden, so dass Einheiten gemäß Formel (II) oder (III) keine Carbazol-Einheit im Sinne der allgemeinen Formel (la) darstellen. Einheiten gemäß Formel (II) sind dementsprechend Triarylamin-Struktureinheiten, wobei die Struktureinheiten der Formel (III) üblich in Kombination mit weiteren Struktureinheiten bevorzugt Triarylamineinheiten bilden können.

Ein aromatisches Ringsystem im Sinne der vorliegenden Erfindung enthält 6 bis 60, vorzugsweise 6 bis 40 und besonders bevorzugt 6 bis 20 C-Atome im Ringsystem. Das heteroaromatische Ringsystem im Sinne der vorliegenden Erfindung enthält 2 bis 59, vorzugsweise 2 bis 39 und besonders bevorzugt 2 bis 19 C-Atome und mindestens ein Heteroatom im Ringsystem, mit der Maßgabe, dass die Summe aus C-Atomen und Heteroatomen mindestens 5 ergibt. Die Heteroatome sind vorzugsweise ausgewählt aus Si, N, P, O, S und/oder Se. Unter einem aromatischen oder heteroaromatischen Ringsystem im Sinne der vorliegenden Erfindung soll darüber hinaus ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10% der von H verschiedenen Atome), wie z.B. ein sp³-hybridisiertes C-Atom, ein N- oder O-Atom, unterbrochen sein können. So sollen beispielsweise auch Systeme wie 9,9'-Spirobifluoren, 9,9-Diarylfluoren, Triarylamin, Diarylether und Stilben, als aromatische Ringsysteme im Sinne der vorliegenden Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. P=O- oder C=O-Gruppen sind gewöhnlich nicht konjugationsunterbrechend.

Als aromatisches oder heteroaromatisches Ringsystem mit 5 bis 60 Ringatomen, welches noch jeweils mit beliebigen Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin, Benzothiadiazol, Benzanthren, Benzanthracen, Rubicen und Triphenylen. Besonders bevorzugt im Sinne der vorliegenden Erfindung sind Fluoren, Spirobifluoren, Indenofluoren, Anthracen, Phenanthren, Dihydrophenanthren und Carbazol.

Im Rahmen der vorliegenden Erfindung werden unter einer Alkylgruppe mit 1 bis 40 C-Atomen, in der auch einzelne H-Atome oder CH₂-Gruppen durch die oben genannten Gruppen oder Reste R substituiert sein können, bevorzugt die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl und Octinyl verstanden. Unter einer Alkoxygruppe mit 1 bis 40 C-Atomen werden vorzugsweise Methoxy, Trifluormethoxy, Ethoxy, n-Propoxy, i-Propoxy, n-Butoxy, i-Butoxy, s-Butoxy, t-Butoxy und 2-Methylbutoxy verstanden.

In Formel Ar⁹-Y-Ar⁹ stellt Y eine Abstandsgruppe, auch Spacer genannt, dar. Als Spacer Y können alle Gruppen eingesetzt werden, die dem Fachmann für diesen Zweck bekannt sind. Die beiden Gruppen Ar⁹ können auch direkt miteinander verbunden sein, in diesem Fall stellt Y eine Bindung dar, die von einer Abstandsgruppe unterschieden werden kann.

Vorteile, die für den Fachmann überraschend sind, können unter anderem durch Abstandsgruppen Y erzielt werden, die eine Unterbrechung der Konjugation der Aryl- oder Heteroarylgruppen Ar⁹ bzw. des Polymers bewirken.

Gemäß einer besonderen Ausführungsform ist Y in Formel Ar⁹-Y-Ar⁹ vorzugsweise eine lineare oder verzweigte Alkylen-Gruppe mit 1 bis 20 C-Atomen, besonders bevorzugt mit 1 bis 12 C-Atomen, in der eine oder mehrere nicht benachbarte CH₂-Gruppen durch -O-, -S-, -NH-, -N(CH₃)-, -N-CO-, N-CO-O-, -N-CO-N, -CO-, -O-CO-, -S-CO-, -O-COO-, -CO-S-, -CO-O-, -CH(Halogen)-, -CH(CN)-, -CH=CH- oder -C≡C- ersetzt sein können, oder eine cyclische Alkylgruppe, bevorzugt Cyclohexan oder ein Cyclohexanderivat mit 1,4- oder 1,3-Verknüpfung. Weitere mögliche Abstandsgruppen Y sind zum Beispiel -(CH₂)ₒ-, -(CH₂CH₂O)ₚ-CH₂CH₂-, -CH₂CH₂-S-CH₂CH₂- oder -CH₂CH₂-NH-CH₂CH₂-, mit o = 1 bis 12, vorzugsweise 2 bis 12, und p = 1 bis 3 aber auch -O-.

Besonders bevorzugte Abstandsgruppen Y sind Methylen, Ethylen, Propylen, Butylen, Pentylen, Hexylen, Heptylen, Octylen, Nonylen, Decylen, Undecylen, Dodecylen, Octadecylen, Ethylenoxyethylen, Methylenoxybutylen, Ethylenthioethylen, Ethylen-N-methyl-iminoethylen, 1-Methylalkylen, Ethenylen, Propenylen und Butenylen.

Insbesondere bevorzugt ist, dass Y eine Alkylen- oder Alkylenoxy-Gruppe mit 2 bis 8 C-Atomen bedeutet. Hierbei sind geradkettige Gruppen besonders bevorzugt.

Gemäß einer weiteren Ausführungsform kann die Abstandsgruppe Y in Formel Ar⁹-Y-Ar⁹ aromatische oder heteroaromatische Ringsysteme enthalten. Hierbei sind insbesondere Abstandsgruppen der Formel (Ya) bevorzugt 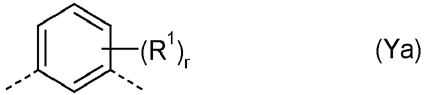 wobei
- R¹: jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes aromatisches oder heteroaromatisches Ring-system mit 5 bis 60 Ringatomen, oder eine Aryloxy- oder Heteroaryl-oxygruppe mit 5 bis 60 Ringatomen, oder eine Kombination dieser Systeme ist, wobei eine oder mehrere der Gruppen R¹ ein mono- oder polycyclisches, aliphatisches oder aromatisches Ringsystem miteinander und/oder mit dem Ring, an dem die Gruppe R¹ gebunden ist, bilden können;
- r: 0, 1, 2, 3 oder 4 ist und
die gestrichelten Linien die Verknüpfungen mit den Aryl- oder Heteroarylgruppen Ar⁹ darstellen.

Vorzugsweise können Einheiten der Formel Ar⁹-Y-Ar⁹ mindestens eine Abstandsgruppe Y der Formel (Yb) enthalten 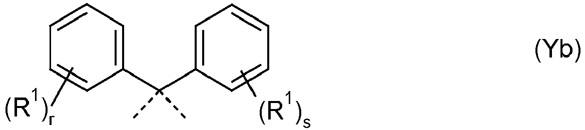 wobei
- R¹: jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ ein mono- oder polycyclisches, aliphatisches oder aromatisches Ring-system miteinander und/oder mit dem Ring, an dem die Gruppe R¹ gebunden ist, bilden können;
- r, s: unabhängig voneinander 0, 1, 2, 3 oder 4 ist und
die gestrichelten Linien die Verknüpfungen mit den Aryl- oder Heteroarylgruppen Ar⁹ darstellen.

Besonders bevorzugt können Einheiten der Formel Ar⁹-Y-Ar⁹ mindestens eine Abstandsgruppe Y der Formel (Yb1) enthalten 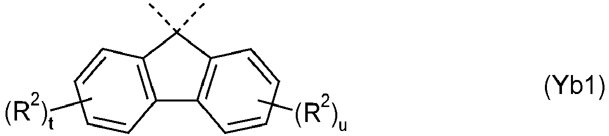 wobei
- R²: jeweils unabhängig eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruuppe, eine CF₃-Gruppe, Cl, Br, F, eine vernetzbare Gruppe oder ein substituiertes oder unsubstituiertes, aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R² ein mono- oder polycyclisches, aliphatisches oder aromatisches Ring-system miteinander und/oder mit dem Ring, an dem die Gruppe R² gebunden ist, bilden können;
- t, u: unabhängig voneinander 0, 1, 2, 3 oder 4 ist und
die gestrichelten Linien die Verknüpfungen mit den Aryl- oder Heteroarylgruppen Ar⁹ darstellen.

Besonders überraschende Vorteile zeigen insbesondere Einheiten der Formel Ar⁹-Y-Ar⁹, die mindestens eine Abstandsgruppe Y der Formel (Yb2) enthalten 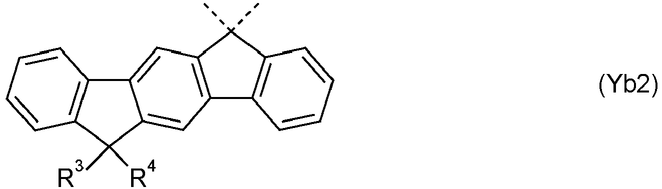 wobei
- R³, R⁴: jeweils unabhängig voneinander ein Wasserstoffatom, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes aromatisches oder heteroaromatisches Ringsystem mit 5 bis 60 Ring-atomen, oder eine Aryloxy- oder Heteroaryloxygruppe mit 5 bis 60 Ringatomen, oder eine Kombination dieser Systeme ist, wobei eine oder mehrere der Gruppen R³, R⁴ ein mono- oder polycyclisches, aliphatisches oder aromatisches Ringsystem miteinander und/oder mit einem anderen Ring bilden können und
die gestrichelten Linien die Verknüpfungen mit den Aryl- oder Heteroarylgruppen Ar⁹ darstellen.

Gemäß einer bevorzugten Ausführungsform der vorliegenden Erfindung enthält die elektronische Vorrichtung Polymere, welche mindestens eine Carbazol-Struktureinheit der allgemeinen Formel (Ib) enthalten 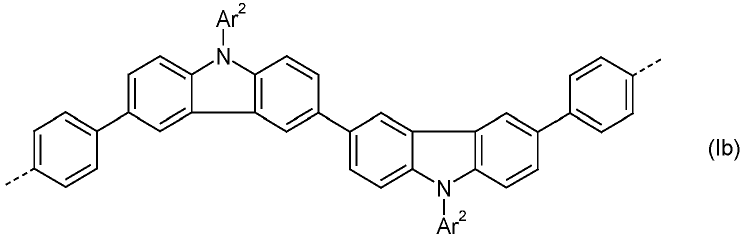 wobei
- Ar²: jeweils unabhängig voneinander eine Aryl- oder Heteroarylgruppe ist, welche mit einem oder mehreren beliebigen Resten R substituiert sein kann, und
die gestrichelten Linien die Verknüpfung im Polymer darstellen.

Der Rest Ar² hat in Formel (Ib) die zuvor für Formel (la) angegebene Bedeutung.

Der Anteil an Carbazol-Struktureinheit der allgemeinen Formel (la) und (Ib) im erfindungsgemäßen Polymer beträgt gemäß einer bevorzugten Ausführungsform der vorliegenden Erfindung mindestens 5 mol%, besonders bevorzugt mindestens 10 mol%, ganz besonders bevorzugt mindestens 20 mol% und insbesondere mindestens 40 mol%.

Überraschende Vorteile lassen sich mit erfindungsgemäßen Polymeren erzielen, die vorzugsweise mindestens eine Arylamin-Struktureinheit der allgemeinen Formel (IIa) und/oder (IIIa) enthalten 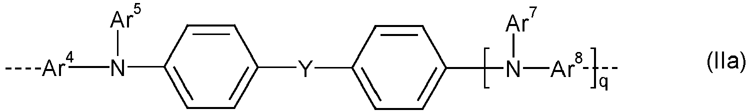 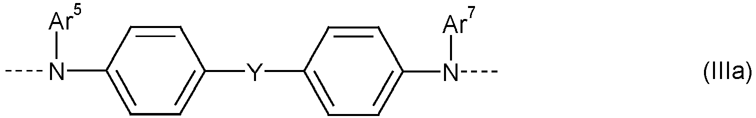 wobei
- Ar⁴, Ar⁵, Ar⁷, Ar⁸: jeweils unabhängig voneinander eine Aryl- oder Heteroarylgruppe ist, welche mit einem oder mehreren beliebigen Resten R substituiert sein kann;
- q: 0 oder 1, vorzugsweise 1, ist;
- Y: eine Abstandsgruppe oder eine direkte Bindung ist und
die gestrichelten Linien die Verknüpfung im Polymer darstellen.

In den Formeln (IIa) und/oder (IIIa) haben die Reste Ar⁴, Ar⁵, Ar⁷, Ar⁸, der Index q und die Abstandsgruppe Y die zuvor für die Formeln (II) und/oder (III) angegebene Bedeutung. Vorzugsweise kann die Abstandsgruppe Y eine Unterbrechung der Konjugation der Arylgruppen bzw. des Polymers bewirken, wie dies zuvor ausführlich dargelegt wurde.

Weiterhin sind Polymere bevorzugt, die mindestens eine Arylamin-Struktureinheit der allgemeinen Formel (IIIb) enthalten 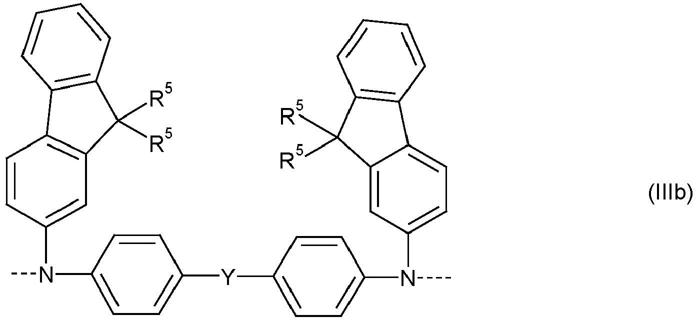 wobei
- Y: eine Abstandsgruppe oder eine direkte Bindung ist;
- R⁵: jeweils unabhängig ein Wasserstoffatom, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R⁵ ein mono- oder polycyclisches, aliphatisches oder aromatisches Ring-system miteinander und/oder mit dem Ring, an dem die Gruppe R⁵ gebunden ist, bilden können,
und die gestrichelten Linien die Verknüpfung im Polymer darstellen.

Der Anteil an Arylamin-Struktureinheiten der allgemeinen Formeln (II), (IIa), (III), (IIIa) und (IIIb) im erfindungsgemäßen Polymer beträgt gemäß einer bevorzugten Ausführungsformen der vorliegenden Erfindung mindestens 5 mol%, besonders bevorzugt mindestens 10 mol%, ganz besonders bevorzugt mindestens 20 mol% und insbesondere mindestens 40 mol%.

Das molare Verhältnis von Carbazol-Struktureinheiten der allgemeinen Formeln (la) und (Ib) zu Arylamin-Struktureinheiten der allgemeinen Formeln (II), (IIa), (III), (IIIa) und (IIIb) liegt vorzugsweise im Bereich von 10:1 bis 1:10, besonders bevorzugt im Bereich von 5:1 bis 1:5 und ganz besonders bevorzugt im Bereich von 2:1 bis 1:2.

Die erfindungsgemäßen Polymere können neben einer oder mehrerer Struktureinheiten der allgemeinen Formeln (la), (II) und/oder (III) noch weitere Struktureinheiten enthalten.

Vorteile, die für den Fachmann überraschend sind, können unter anderem durch Polymere erzielt werden, die Verbindungsstruktureinheiten umfassen. Besonders bevorzugte Verbindungsstruktureinheiten können eine Unterbrechung der Konjugation des Polymers bewirken.

Bevorzugte Verbindungsstruktureinheiten entsprechen der Formel (IV) 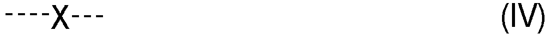 wobei
- X: eine Abstandsgruppe ist und
die gestrichelten Linien die Verknüpfung im Polymer darstellen.

Zu den bevorzugten Abstandsgruppen X gehören unter anderem lineare oder verzweigte Alkylen-Gruppen mit 1 bis 20 C-Atomen, besonders bevorzugt mit 1 bis 12 C-Atomen, in der eine oder mehrere nicht benachbarte CH₂-Gruppen durch -O-, -S-, -NH-, -N(CH₃)-, -N-CO-, -N-CO-O-, -N-CO-N, -CO-, -O-CO-, -S-CO-, -O-COO-, -CO-S-, -CO-O-, -CH(Halogen)-, -CH(CN)-, -CH=CH- oder -C≡C- ersetzt sein können, oder cyclische Alkylgruppen, bevorzugt Cyclohexan oder ein Cyclohexanderivat mit 1,4- oder 1,3-Verknüpfung. Weitere mögliche Abstandsgruppen X sind zum Beispiel -(CH₂)ₒ-, -(CH₂CH₂O)ₚ-CH₂CH₂-, -CH₂CH₂-S-CH₂CH₂- oder -CH₂CH₂-NH-CH₂CH₂-, mit o = 1 bis 12, vorzugsweise 2 bis 12, und p = 1 bis 3 aber auch -O-.

Besonders bevorzugte Abstandsgruppen X sind Methylen, Ethylen, Propylen, Butylen, Pentylen, Hexylen, Heptylen, Octylen, Nonylen, Decylen, Undecylen, Dodecylen, Octadecylen, Ethylenoxyethylen, Methylenoxybutylen, Ethylenthioethylen, Ethylen-N-methyl-iminoethylen, 1-Methylalkylen, Ethenylen, Propenylen und Butenylen.

Insbesondere bedeutet X eine Alkylen- oder Alkylenoxy-Gruppe mit 2 bis 8 C-Atomen. Hierbei sind geradkettige Gruppen besonders bevorzugt.

Gemäß einer weiteren Ausführungsform kann die Verbindungsstruktureinheit aromatische oder heteroaromatische Ringsysteme enthalten.

Hierbei sind insbesondere Verbindungsstruktureinheiten der Formel (Va) bevorzugt 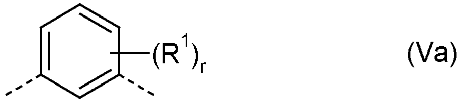 wobei
- R¹: jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ring-system mit 5 bis 60 Ringatomen, oder eine Aryloxy- oder Heteroaryl-oxygruppe mit 5 bis 60 Ringatomen, oder eine Kombination dieser Systeme ist, wobei eine oder mehrere der Gruppen R¹ ein mono- oder polycyclisches, aliphatisches oder aromatisches Ringsystem miteinander und/oder mit dem Ring, an dem die Gruppe R¹ gebunden ist, bilden können;
- r: 0, 1, 2, 3 oder 4 ist und
die gestrichelten Linien die Verknüpfung im Polymer darstellen.

Weiterhin können vorzugsweise Verbindungsstruktureinheiten der Formel (Vb) eingesetzt werden 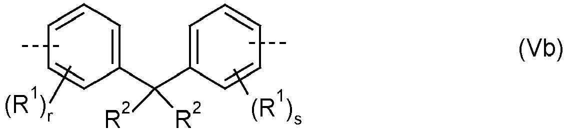 wobei
- R¹, R²: jeweils unabhängig voneinander eine geradkettige Alkyl-, Alkoxy-oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono- oder polycyclisches, aliphatisches oder aromatisches Ringsystem miteinander und/oder mit dem Ring, an dem die Gruppe R¹ gebunden ist, bilden können;
- r, s: unabhängig voneinander 0, 1, 2, 3 oder 4 ist und
die gestrichelten Linien die Verknüpfung im Polymer darstellen.

Besonders bevorzugte Polymere enthalten mindestens eine Verbindungsstruktureinheit der Formel (Vb1) 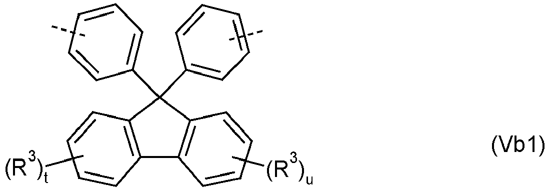 wobei
- R³: jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanat-gruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R³ ein mono- oder polycyclisches, aliphatisches oder aromatisches Ring-system miteinander und/oder mit dem Ring, an dem die Gruppe R³ gebunden ist, bilden können;
- t, u: unabhängig voneinander 0, 1, 2, 3 oder 4 ist und
die gestrichelten Linien die Verknüpfung im Polymer darstellen.

Besonders überraschende Vorteile zeigen insbesondere Polymere, die mindestens eine Verbindungsstruktureinheit der Formel (Vb2) enthalten 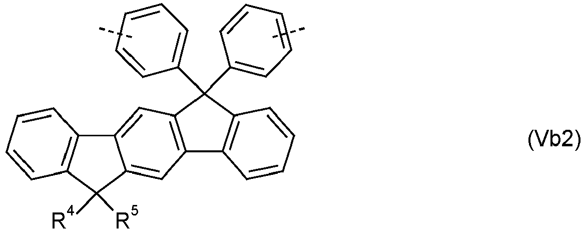 wobei
- R⁴, R⁵: jeweils unabhängig voneinander ein Wasserstoffatom, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ring-atomen, oder eine Aryloxy- oder Heteroaryloxygruppe mit 5 bis 60 Ringatomen, oder eine Kombination dieser Systeme ist, wobei eine oder mehrere der Gruppen R⁴, R⁵ ein mono- oder polycyclisches, aliphatisches oder aromatisches Ringsystem miteinander und/oder mit einem anderen Ring bilden können und
die gestrichelten Linien die Verknüpfung im Polymer darstellen.

Der Anteil an Verbindungsstruktureinheiten, insbesondere denen gemäß den obigen Formeln (IV), (Va) ,(Vb), (Vb1) und (Vb2), im erfindungsgemäßen Polymer liegt gemäß einer bevorzugten Ausführungsformen der vorliegenden Erfindung im Bereich von 0 bis 90 mol%, besonders bevorzugt im Bereich von 1 bis 50 mol% und ganz besonders bevorzugt im Bereich von 5 bis 30 mol%.

Das molare Verhältnis von Carbazol-Struktureinheiten der allgemeinen Formeln (la) und (Ib) zu Verbindungsstruktureinheiten, insbesondere denen gemäß den obigen Formeln (IV), (Va) ,(Vb), (Vb1) und (Vb2), liegt vorzugsweise im Bereich von 100:1 bis 1:10, besonders bevorzugt im Bereich von 50:1 bis 1:5 und ganz besonders bevorzugt im Bereich von 20:1 bis 1:2, falls Verbindungsstruktureinheiten im Polymer enthalten sind.

Gemäß einer weiteren bevorzugten Ausführungsform liegt das molare Verhältnis von Arylamin-Struktureinheiten der allgemeinen Formeln (II), (IIa), (III), (IIIa) und (IIIb) zu Verbindungsstruktureinheiten, insbesondere denen gemäß obigen Formeln (IV), (Va) ,(Vb), (Vb1) und (Vb2), vorzugsweise im Bereich von 100:1 bis 1:10, besonders bevorzugt im Bereich von 50:1 bis 1:5 und ganz besonders bevorzugt im Bereich von 20:1 bis 1:2, falls Verbindungsstruktureinheiten im Polymer enthalten sind.

Unter einem Polymer im Sinne der vorliegenden Erfindung soll auch ein Oligomer und ein Dendrimer verstanden werden.

Als Oligomer wird im Sinne der vorliegenden Erfindung eine Verbindung bezeichnet, welche drei bis neun Wiederholungseinheiten aufweist. Als Polymer im Sinne der vorliegenden Erfindung wird eine Verbindung verstanden, welche zehn oder mehr Wiederholungseinheiten aufweist. Der Verzweigungs-Faktor der Polymeren liegt dabei zwischen 0 (lineares Polymer, ohne Verzweigungsstellen) und 1 (vollständig verzweigtes Dendrimer).

Die Polymere, Oligomere oder Dendrimere können konjugiert, teilkonjugiert oder nicht-konjugiert sein. Die Polymere oder Oligomere können linear, verzweigt oder dendritisch sein. In den linear verknüpften Strukturen können die Einheiten der allgemeinen Formeln (la), (II) und/oder (III) sowohl direkt miteinander verknüpft sein oder sie können über eine bivalente Gruppe, beispielsweise über eine substituierte oder unsubstituierte Alkylengruppe, über ein Heteroatom oder über eine bivalente aromatische oder heteroaromatische Gruppe, miteinander verknüpft sein. In verzweigten Strukturen können beispielsweise drei oder mehrere Einheiten der allgemeinen Formeln (I), (II) und/oder (III) über eine trivalente oder höhervalente Gruppe, beispielsweise über eine trivalente oder höhervalente aromatische oder heteroaromatische Gruppe, zu einem verzweigten Polymer oder Oligomer verknüpft sein.

Vorzugsweise weisen die Polymere der vorliegenden Erfindung ein Gewichtsmittel des Molekulargewichts M_{w} im Bereich von 10000 bis 2000000 g/mol, besonders bevorzugt im Bereich von 20000 bis 1000000 g/mol und ganz besonders bevorzugt im Bereich von 50000 bis 500000 g/mol auf. Das Gewichtsmittel des Molekulargewichts M_{w} kann durch übliche Methoden, insbesondere durch Gelpermeationschromatographie (GPC) bestimmt werden.

Die Herstellung der Polymere erfolgt unter Verwendung von bekannten Methoden, wobei funktionalisierte Verbindungen copolymerisiert werden. Diese funktionalisierten Verbindungen enthalten die zuvor dargelegten Struktureinheiten der obigen Formeln sowie mindestens zwei Abgangsgruppen, wie Brom, lod, Boronsäure oder Boronsäureester.

Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA. Die C-C-Verknüpfungen werden besonders bevorzugt über eine SUZUKI-Kupplung durchgeführt.

Überraschende Vorteile können insbesondere durch Polymere erzielt werden, die durch eine BUCHWALD-Reaktion erhalten werden. Hierbei wird ein aromatisches Diamin mit einem Arylhalogenid umgesetzt. Bevorzugte funktionale Monomere, die unter Verwendung der BUCHWALD-Reaktion umgesetzt werden können sind insbesondere Halogenide, die Carbazol-Struktureinheiten der Formel (la) oder (Ib) enthalten, und Diamine mit zwei sekundären Stickstoffatomen, die Struktureinheiten der Formel (III), (IIIa) oder (IIIb) enthalten.

Demzufolge entsprechen bevorzugte Carbazol-Monomere zur Herstellung der erfindungsgemäßen Polymere den Formeln (M Ia) und (M Ib) 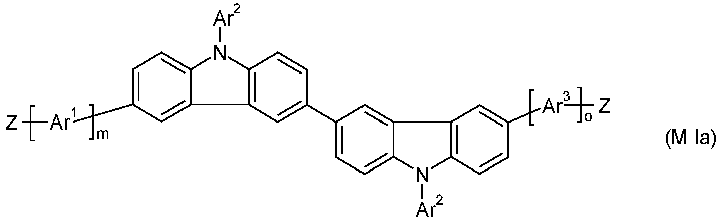 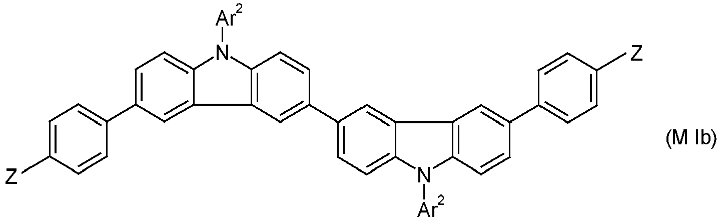 wobei
- Ar¹, Ar², Ar³: jeweils unabhängig voneinander eine Aryl- oder Heteroarylgruppe ist, welche mit einem oder mehreren beliebigen Resten R substituiert sein kann;
- m, o: unabhängig voneinander 0 oder 1 ist;
- n: 1, 2 oder 3 ist und
- Z: jeweils unabhängig eine Abgangsgruppe ist.

Bevorzugte Arylamin-Monomere zur Herstellung der erfindungsgemäßen Polymere entsprechen den Formeln (M II) und (M IIa) 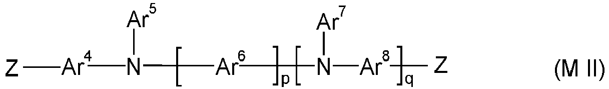 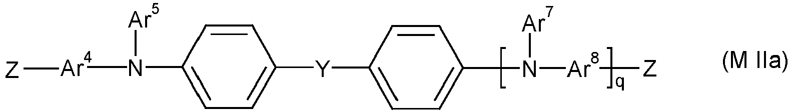 wobei
- Ar⁴, Ar⁵, Ar⁷, Ar⁸: jeweils unabhängig voneinander eine Aryl- oder Heteroarylgruppe ist, welche mit einem oder mehreren beliebigen Resten R substituiert sein kann;
- Ar⁶: eine Aryl- oder Heteroarylgruppe ist, welche mit einem oder mehreren beliebigen Resten R substituiert sein kann oder eine Gruppe der Formel Ar⁹-Y-Ar⁹ darstellt, wobei Ar⁹ jeweils unabhängig eine Aryl-oder Heteroarylgruppe ist, welche mit einem oder mehreren beliebigen Resten R substituiert ist oder welche miteinander verknüpft sein können;
- Y: eine Abstandsgruppe oder eine direkte Bindung ist;
- p: 1, 2 oder 3 ist;
- q: 0 oder 1 ist und
- Z: jeweils unabhängig eine Abgangsgruppe ist.

Die Arylamin-Monomere gemäß den Formeln (M II) und (M IIa) können insbesondere gemäß der zuvor dargelegten SUZUKI-Reaktion mit den zuvor dargelegten Carbazol-Monomeren polymerisiert werden.

Besonders bevorzugt werden weiterhin Arylamin-Monomere gemäß den Formel (M III), (M IIIa) und (M IIIb) eingesetzt 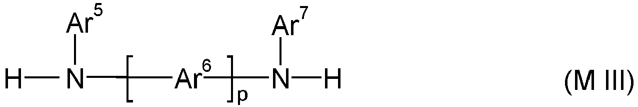 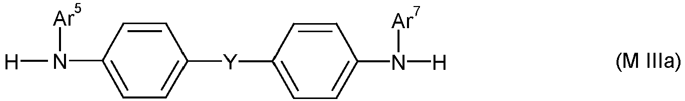 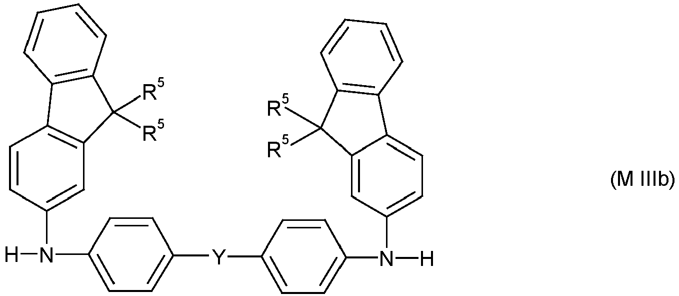 wobei
- Ar⁵, Ar⁷: jeweils unabhängig voneinander eine Aryl- oder Heteroarylgruppe ist, welche mit einem oder mehreren beliebigen Resten R substituiert sein kann;
- Ar⁶: eine Aryl- oder Heteroarylgruppe ist, welche mit einem oder mehreren beliebigen Resten R substituiert sein kann oder eine Gruppe der Formel Ar⁹-Y-Ar⁹ darstellt, wobei Ar⁹ jeweils unabhängig voneinander eine Aryl- oder Heteroarylgruppe ist, welche mit einem oder mehreren beliebigen Resten R substituiert ist oder welche miteinander verknüpft sein können, und Y eine Abstandsgruppe oder eine direkte Bindung ist;
- R⁵: jeweils unabhängig voneinander ein Wasserstoffatom, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ring-atomen, oder eine Aryloxy- oder Heteroaryloxygruppe mit 5 bis 60 Ringatomen, oder eine Kombination dieser Systeme ist, wobei eine oder mehrere der Gruppen R⁵ ein mono- oder polycyclisches, aliphatisches oder aromatisches Ringsystem miteinander und/oder mit einem anderen Ring bilden können, und
- p: 1, 2 oder 3 ist.

Die Arylamin-Monomere gemäß den Formeln (M III), (M IIIa) und (M IIIb) können insbesondere gemäß zuvor dargelegter BUCHWALD-Reaktion mit den Carbazol-Monomeren umgesetzt werden.

Zu den besonders bevorzugten Comonomeren, die zur Einfügung von Verbindungsstruktureinheiten, insbesondere gemäß den Formeln (IV), (Va) und (Vb), eingesetzt werden können, gehören unter anderem Verbindungen mit zwei Abgangsgruppen, wie Brom, lod, Boronsäure oder Boronsäureestern, die die genannten Struktureinheiten enthalten.

Darüber hinaus kann das Polymer weitere Wiederholungseinheiten enthalten, die von funktionalen Comonomeren abgeleitet sind.

Ferner kann die Zusammensetzung zur Herstellung der Polymere weitere reaktive Verbindungen, insbesondere monofunktionale Verbindungen enthalten, mit denen eine Steuerung des Molekulargewichts möglich ist. Diese Verbindungen entsprechen den zuvor dargelegten Monomeren, weisen jedoch anstatt zwei oder mehr lediglich eine Abgangsgruppe, vorzugsweise Brom, lod, eine Boronsäure- oder eine Boronsäureester-Gruppe auf. Im Falle der Buchwaldreaktion können auch monofunktionale Amine verwendet werden.

Wie die Polymerisation nach diesen Methoden durchgeführt werden kann und wie die Polymere dann vom Reaktionsmedium abgetrennt und gereinigt werden können, ist dem Fachmann bekannt und in der Literatur, beispielsweise in der WO 03/048225 und der WO 04/037887, im Detail beschrieben.

Die Polymere, Oligomere oder Dendrimere, welche die oben genannten Struktureinheiten enthalten, finden beispielsweise zur Herstellung von OLEDs bzw. PLEDs Verwendung, und zwar in der Lochinjektionsschicht und/oder in der Lochtransportschicht.

Die Erzeugung der Polymerschicht kann beispielsweise durch Beschichtung aus Lösung, vorzugsweise Spin-Coating, erfolgen.

Die organische, elektronische Vorrichtung ist vorzugsweise eine organische elektrolumineszierende Vorrichtung (OLED), eine polymere elektrolumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), eine lichtemittierende elektrochemische Zelle (LEC) oder eine organische Laserdiode (O-Laser).

Im Sinne der vorliegenden Erfindung ist es bevorzugt, dass das Polymer, Oligomer oder Dendrimer als Schicht (oder in einer Schicht) in der elektronischen Vorrichtung vorliegt.

Die Polymere und Copolymere können ferner linear oder verzweigt sein. Die Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, wird beispielsweise ausführlich in der WO 05/014688 beschrieben. Diese Schrift ist via Zitat Bestandteil der vorliegenden Anmeldung.

In einer weiteren Ausführungsform der vorliegenden Erfindung umfasst die Vorrichtung mehrere Schichten. Das Polymer, Oligo-mer oder Dendrimer ist dabei in einer Lochtransport- und/oder Lochinjektionsschicht enthalten.

Die Dicke der Lochtransport- und/oder Lochinjektionsschicht liegt vorzugsweise im Bereich von 1 bis 500 nm, besonders bevorzugt im Bereich von 2 bis 200 nm.

Die Vorrichtung kann ferner Schichten enthalten, welche aus niedermolekularen Verbindungen (sog. Small Molecules; SMOLED) aufgebaut sind. Diese können durch Verdampfen der niedermolekularen Verbindungen im Hochvakuum erzeugt werden.

Es kann außerdem bevorzugt sein, das Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren.

Die organische Elektrolumineszenzvorrichtung kann eine emittierende Schicht enthalten oder sie kann mehrere emittierende Schichten enthalten. Wenn mehrere Emissionsschichten vorhanden sind, weisen diese vorzugsweise insgesamt mehrere Emissionsmaxima zwischen 380 nm und 750 nm auf, so dass insgesamt weiße Emission resultiert, d.h. in den emittierenden Schichten werden verschiedene emittierende Verbindungen verwendet, die fluoreszieren oder phosphoreszieren können. Ganz besonders bevorzugt sind Dreischichtsysteme, wobei die drei Schichten blaue, grüne und orange oder rote Emission zeigen (für den prinzipiellen Aufbau siehe z.B. WO 05/011013). Weiß emittierende Vorrichtungen eignen sich z.B. als Beleuchtung oder Hintergrundbeleuchtung von Displays (LCD).

Außer diesen Schichten kann die organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Excitonenblockierschichten und/oder Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Laye*r*)*.* Ebenso können zwischen zwei emittierende Schichten Interlayer eingebracht sein, welche beispielsweise eine Excitonen-blockierende Funktion aufweisen. Es sei aber darauf hingewiesen, dass nicht notwendigerweise jede dieser Schichten vorhanden sein muss. Diese Schichten können ebenfalls die Polymere, Oligomere oder Dendrimere, wie oben definiert, enthalten. Möglich ist auch, dass mehrere OLEDs übereinander angeordnet werden, wodurch eine weitere Effizienzsteigerung hinsichtlich der Lichtausbeute erreicht werden kann. Zur Verbesserung der Lichtauskopplung kann die letzte organische Schicht auf der Lichtaustrittseite bei OLEDs beispiels-weise auch als Nanoschaum ausgeführt sein, wodurch der Anteil der Totalreflexion verringert wird.

Weiterhin bevorzugt ist eine organische Elektrolumineszenzvorrichtung, wobei eine oder mehrere Schichten mit einem Sublimationsverfahren aufgebracht werden. Dabei werden die Materialien in Vakuum-Sublimationsanlagen bei einem Druck kleiner 10⁻⁵ mbar, vorzugsweise kleiner 10⁻⁶ mbar, besonders bevorzugt kleiner 10⁻⁷ mbar aufgedampft.

Bevorzugt ist ebenfalls eine organische Elektrolumineszenzvorrichtung, die dadurch gekennzeichnet ist, dass eine oder mehrere Schichten mit dem OVPD (Organic Vapour Phase Deposition) Verfahren oder mit Hilfe einer Trägergassublimation aufgebracht werden. Dabei werden die Materialien bei einem Druck zwischen 10⁻⁵ mbar und 1 bar aufgebracht.

Weiterhin bevorzugt ist eine organische Elektrolumineszenzvorrichtung, die dadurch gekennzeichnet ist, dass eine oder mehrere Schichten aus Lösung, wie z.B. durch Spin-Coating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), aufgebracht werden. Hierfür sind lösliche Verbindungen nötig, welche gegebenenfalls durch geeignete Substitution erhalten werden.

Die Vorrichtung enthält gewöhnlich eine Kathode und eine Anode (Elektroden). Die Elektroden (Kathode, Anode) werden im Sinne der vorliegenden Erfindung so gewählt, dass ihr Potential möglichst gut mit dem Potential der angrenzenden, organischen Schicht übereinstimmt, um eine möglichst effiziente Elektronen- bzw. Lochinjektion zu gewährleisten.

Als Kathode sind Metallkomplexe, Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z.B. Ca, Ba, Mg, Al, In, Mg, Yb und Sm). Bei mehrlagigen Strukturen können auch zusätzlich zu den genannten Metallen weitere Metalle verwendet werden, die eine relativ hohe Austrittsarbeit aufweisen, wie z.B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide in Frage (z.B. LiF, Li₂O, BaF₂, MgO und NaF). Die Schichtdicke dieser Schicht liegt vorzugsweise zwischen 1 und 10 nm, besonders bevorzugt zwischen 2 und 8 nm.

Als Anode sind Materialien mit hoher Austrittsarbeit bevorzugt. Vorzugsweise weist die Anode ein Potential größer 4,5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z.B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige, gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, wie z.B Poly(ethylendioxy-thiophen) (PEDOT) und Polyanilin (PANI).

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die Erfindung wird im Folgenden anhand von Ausführungsbeispielen näher erläutert, ohne dadurch jedoch beschränkt zu werden.

### Ausführungsbeispiele

### A) Herstellung der Monomere

### Beispiel 1 (Herstellung von Verbindung 3)

Die Verbindung 3 wird wie folgt hergestellt:

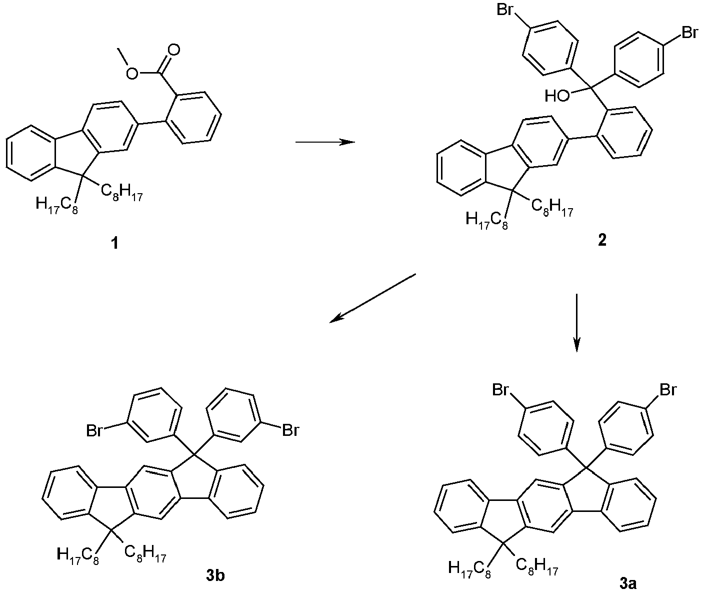

### Verbingung 2

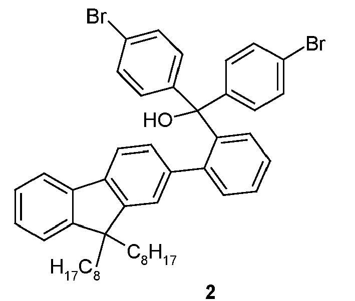

104,3 g (2 molare Äquivalente, 0,442 mol) 1,4-Dibrombenzol werden in 300 ml THF vorgelegt und im Aceton/Trockeneisbad auf -75°C abgekühlt. 117 ml (2 molare Äquivalente, 0,442 mol) n-Butyllithium (2,5 M in Hexan) werden so zugetropft, dass die Innentemperatur -69°C nicht übersteigt, anschließend wird 1 Stunde bei -72°C weiter gerührt. Danach werden 116 g (1 molares Äquivalent, 0,221 mol) Verbindung 1 in 220 ml THF gelöst und bei -72°C langsam zugetropft, dass die Innentemperatur -69°C nicht übersteigt. Die Reaktionslösung wird für eine weitere Stunde bei -70°C und über Nacht bei Raumtemperatur gerührt. Der Ansatz wird mit 120 ml Essigsäure 50%ig versetzt. Die Phasen werden getrennt. Die wässrige Phase wird mit Heptan extrahiert. Die vereinigten organischen Phasen werden mit Wasser extrahiert, über Na₂SO₄ getrocknet, filtriert und unter vermindertem Druck eingeengt.
¹H NMR (CDCl₂, δ (ppm), *J* (Hz)): 0.51 (s breit, 4H), 0.81 (t, 6H, J = 7.25), 0.94 - 1.25 (m, 20H), 1.55 - 1.85 (m, 4H), 6.73 (d, 1H, J = 8.0), 6.87 - 6.90 (m, 2H), 6.95 - 7.05 (m breit, 4H), 7.21 (d, 1H, J = 7.55), 7.24 (d, 1H, J = 7.75), 7.28 -7.36 (m, 4H), 7.42 (d, 4H, J = 8.6), 7.56 (d, 1H, 7.75), 7.66 - 7.68 (m, 1H)

### Verbingung 3a

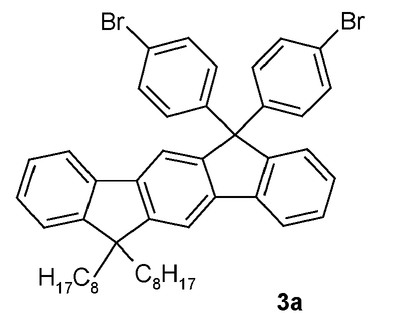

177,4 g (1 molares Äquivalent, 0,22 mol) Verbindung 2 werden in 353,2 ml (2,8 molare Äquivalente, 6,1 mol) Essigsäure gelöst und auf Rückfluss erwärmt. Unter Rückfluss werden 19,6 ml (1,1 molare Äquivalente, 0,24 mol) konzentrierte Salzsäure zugegeben und 1,5 Stunden unter Rückfluss erhitzt. Nach DC-Kontrolle (Heptan/Essigester) erfolgt eine Nachdosierung von 2 x 2 ml konzentrierter Salzsäure, Reaktionszeit 3 Stunden. Nach beendeter Reaktion wird vorsichtig 25 ml Wasser zugegeben. Anschließend wird zur Phasentrennung nochmals 50 ml Wasser zugegeben. Es wird mit Dichlormethan extrahiert, danach werden die vereinigten organischen Phasen mit Wasser und NaHCO₃ extrahiert, über Natriumsulfat getrocknet, filtriert und unter vermindertem Druck eingeengt.

Die Reinigung erfolgt durch Umkristallisation (Acetonitril/Toluol) und liefert einen weißen Feststoff (99%).
¹H NMR (CDCl₂, δ (ppm), *J* (Hz)): 0.65 - 0.75 (m, 4H), 0.79 (t, 6H, J = 7.25), 0.99 - 1.25 (m, 20H), 1.98 - 2.01 (m, 4H), 7.10 (d, 4H, J = 8.75), 7.26 - 7.29 (m, 3H), 7.33 - 7.41 (m, 7H), 7.57 (s, 1H), 7.60 - 7.62 (m, 1H), 7.71 (s, 1H), 7.84 (d, 1H, 7.55)

### Verbingung 3b

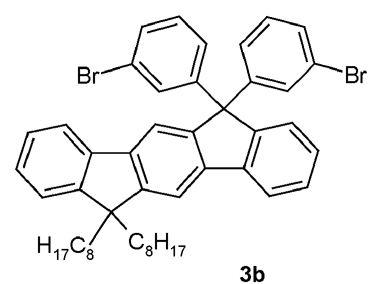

Verbindung 3b wird analog zu Verbindung 3a hergestellt unter Verwendung von 1,3-Dibrombenzol als käuflichem Edukt.
¹H NMR (CDCl₂, δ (ppm), *J* (Hz)): 0.65 - 0.75 (m, 4H), 0.79 (t, 6H, J = 7.25), 0.99 - 1.25 (m, 20H), 1.98 - 2.01 (m, 4H), 7.10 (d, 4H, J = 8.75), 7.26 - 7.29 (m, 3H), 7.33 - 7.41 (m, 7H), 7.57 (s, 1H), 7.60 - 7.62 (m, 1H), 7.71 (s, 1H), 7.84 (d, 1H, 7.55)

### Beispiel 2 (Herstellung von Verbindung 6)

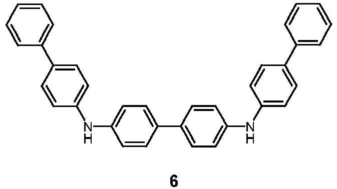

Die Verbindung **6** wird wie folgt hergestellt:

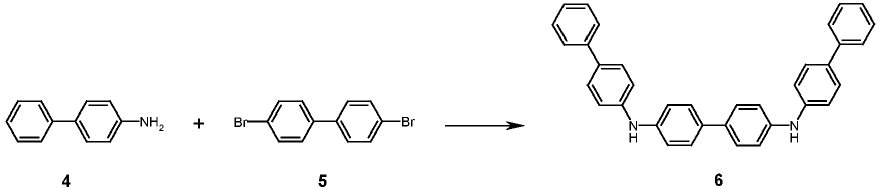

25 g 4-Aminobiphenyl **4** (148 mmol), 22,6 g (72 mmol) 4,4'-Dibrombiphenyl **5** und 21,4 g Natrium-tert-Butylat (222 mmol) werden in Toluol gelöst und die Reaktionslösung sorgfällig entgast. Die Reaktionslösung wird auf 80°C erwärmt und die Reaktion durch Zugabe des Katalysators 325 mg (0,36 mmol) Pd₂dba₃ und 451 mg (0,73 mmol) BINAP gestartet und auf Rückflusstemperatur erhitzt. Der Fortschritt der Reaktion wird mittels Dünnschichtchromatographie verfolgt. Nach Beendigung der Reaktion wird auf Raumtemperatur abgekühlt und mit 50 ml Wasser versetzt. Es werden die Phasen getrennt, die wässrige zweimal mit 50 ml Toluol extrahiert. Die vereinigten organischen Phasen werden dreimal mit 50 ml Wasser gewaschen, über Magnesiumsulfat getrocknet, und das Lösungsmittel im Vakuum abgezogen. Das Rohprodukt wird aus Toluol umkristallisiert.

### Beispiele 3 bis 5 (Herstellung der Verbindungen 11 bis 13)

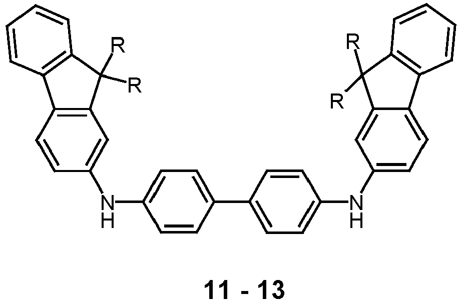

Die Verbindungen **11** bis **13** werden wie folgt hergestellt: 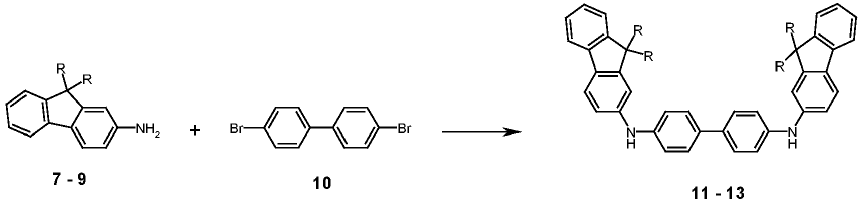
Die N,N'-Dialkyldifluorenbenzidine **11** bis **13** werden analog der Synthese des Dibiphenylbenzidins erhalten (siehe Beispiel 2).
N,N'-Bis-(dimethylfluoren)-benzidin **11**
N,N'-Bis-(dibutylfluoren)-benzidin **12**
N,N'-Bis-(dioctylfluoren)-benzidin **13**

### Beispiele 6 bis 8 (Herstellung der Verbindungen 15 bis 17)

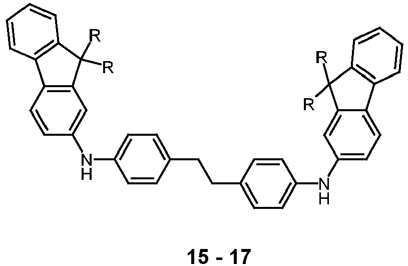

Die Verbindungen **15** bis **17** werden wie folgt hergestellt:

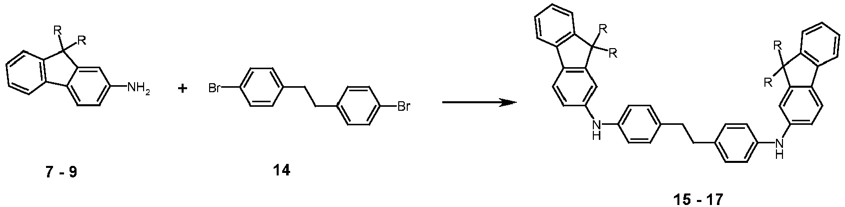

13,9 g 4-Aminodimethylfluoren **7** (66 mmol), 11 g (32 mmol) 4,4'-Dibrombibenzyl **14** und 9,4 g Natrium-tert-Butylat (97 mmol) werden in Toluol gelöst und die Reaktionslösung sorgfällig entgast. Die Reaktionslösung wird auf 80°C erwärmt und die Reaktion durch Zugabe des Katalysators 148 mg (0,16 mmol) Pd₂dba₃ und 201 mg (0,32 mmol) BINAP gestartet und auf Rückflusstemperatur erhitzt. Der Fortschritt der Reaktion wird mittels Dünnschichtchromatographie verfolgt. Nach Beendigung der Reaktion wird auf Raumtemperatur abgekühlt und mit 30 ml Wasser versetzt. Es werden die Phasen getrennt, die wässrige zweimal mit 30 ml Toluol extrahiert. Die vereinigten organischen Phasen werden dreimal mit 30 ml Wasser gewaschen, über Magnesiumsulfat (MgSO₄) getrocknet, und das Lösungsmittel im Vakuum abgezogen. Das Rohprodukt wird aus Toluol umkristallisiert.
Die N,N'-Bis-(dialkylfluoren)-diaminobibenzyle **15** bis **17** werden analog der Synthese des Dibiphenylbenzidins erhalten (siehe Beispiel 2).
N,N'-Bis-(dimethylfluoren)-diaminobibenzyl **15**
N,N'-Bis-(dibutylfluoren)-diaminobibenzyl **16**
N,N'-Bis-(dioctylfluoren)-diaminobibenzyl **17**

### Beispiel 9 (Herstellung von Verbindung 23)

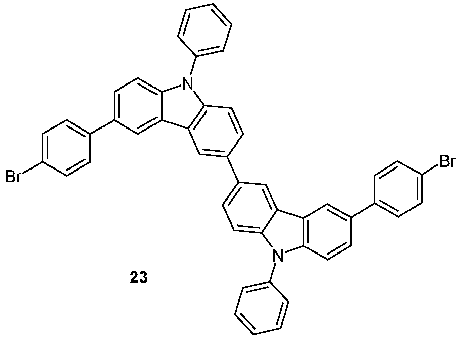

Die Verbindung **23** wird nach folgender Synthesesequenz erhalten: 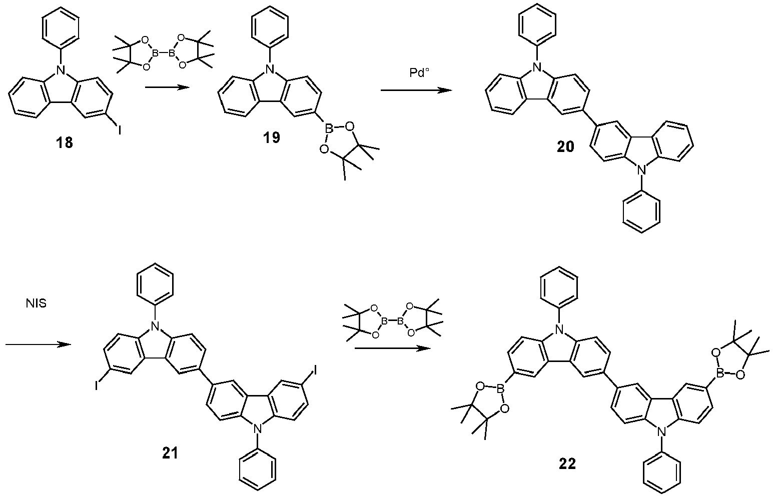 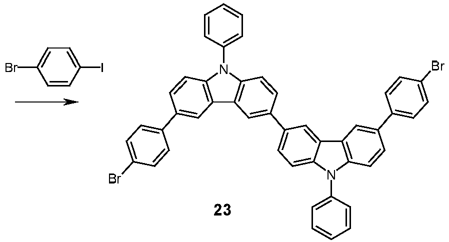
Phenylcarbazolboronester **19:**
   150 g (406 mmol) 3-lodphenylcarbazol **18** werden in 800 ml Dioxan gelöst und mit 123,8 g (488 mol) Bis(pinacolato)diboran und 131,6 g (1,34 mol) Kaliumacetat versetzt. Anschließend werden 3,2 g (4,1 mmol) 1,1-Bis(diphenylphosphino)-ferrocen-palladium(II)chlorid (Komplex mit Dichlormethan (1:1), Pd 13%) zugegeben. Die Reaktion wird auf 110°C erhitzt. Der Fortschritt der Reaktion wird mittels Dünnschichtchromatographie verfolgt. Nach beendeter Reaktion wird der Ansatz auf Raumtemperatur abgekühlt und mit 200 ml Wasser versetzt. Es werden die Phasen getrennt. Die organische Phase zweimal mit 100 ml Wasser extrahiert. Die vereinigten organischen Phasen werden dreimal mit 100 ml Wasser gewaschen, über Magnesiumsulfat getrocknet, filtriert und das Lösungsmittel im Vakuum abgezogen. Das Rohprodukt wird aus Heptan umkristallisiert, man erhält einen beigen Feststoff.
Bisphenylcarbazol **20:**
   91 g (242 mmol) 3-lodphenylcarbazol **18** und 91 g (246 mmol) Phenylcarbazolboronester **19** werden in Aceton suspendiert und mit einer 350 ml 20%igen Tetraethylammoniumhydroxidlösung (493 mmol) versetzt, die Mischung sorgfällig mit Argon entgast. Anschließend werden 4,6 g (4 mmol) Tetrakistriphenylphosphinpalladium zugegeben. Die Reaktion wird auf 70°C erhitzt. Der Fortschritt der Reaktion wird mittels Dünnschichtchromatographie verfolgt. Nach beendeter Reaktion wird der Ansatz auf Raumtemperatur abgekühlt und das ausgefallene Produkt abgesaugt. Das Rohprodukt wird aus Acetonitril umkristallisiert, man erhält einen beigen Feststoff.
Diiodbisphenylcarbazol **21:**
   68 g (139 mmol) Bisphenylcarbazol **20** und 68 g (306 mmol) N-lodsuccinimid werden in Eisessig suspendiert und über Nacht bei Raumtemperatur und unter Lichtausschluss gerührt. Der Niederschlag wird abgesaugt und mit Wasser und Heptan gewaschen. Das Rohprodukt wird aus Acetonitril umkristallisiert, man erhält einen weißen Feststoff.
Bisphenylcarbazolbisboronester **22:**
   100 g (136 mmol) Diiodbisphenylcarbazol **21** werden in 500 ml Dioxan gelöst und mit 83 g (326 mol) Bis(pinacolato)diboran und 88 g (896 mmol) Kaliumacetat versetzt. Anschließend werden 2,2 g (2,7 mmol) 1,1-Bis(diphenylphosphino)ferrocen-palladium(II)chlorid (Komplex mit Dichlormethan (1:1), Pd 13%) zugegeben. Die Reaktion wird auf 110°C erhitzt. Der Fortschritt der Reaktion wird mittels Dünnschichtchromatographie verfolgt. Nach beendeter Reaktion wird der Ansatz auf Raumtemperatur abgekühlt und mit 200 ml Wasser versetzt. Es werden die Phasen getrennt. Die organische Phase zweimal mit 100 ml Wasser extrahiert. Die vereinigten organischen Phasen werden dreimal mit 100 ml Wasser gewaschen, über Magnesiumsulfat getrocknet, filtriert und das Lösungsmittel im Vakuum abgezogen. Das Rohprodukt wird aus Heptan umkristallisiert, man erhält einen beigen Feststoff.
Bis-3-(4-Bromphenyl) bisphenylcarbazol **23:**
   30 g (41 mmol) Bisphenylcarbazolbisboronester **22** und 28,8 g (102 mmol) 1-Brom-4-iodbenzol werden in Toluol gelöst und mit einer 82 ml 2M Natriumcarbonatlösung (163 mmol) versetzt, die Mischung sorgfällig mit Argon entgast. Anschließend werden 0,94 g (0,8 mmol) Tetrakistriphenylphosphinpalladium zugegeben. Die Reaktion wird auf 110°C erhitzt. Der Fortschritt der Reaktion wird mittels Dünnschichtchromatographie verfolgt. Nach beendeter Reaktion wird der Ansatz auf Raumtemperatur abgekühlt und das ausgefallene Produkt abgesaugt. Das Rohprodukt wird aus Dimethylformamid umkristallisiert, man erhält einen beigen Feststoff.

### Beispiel 10 (Herstellung von Verbindung 24)

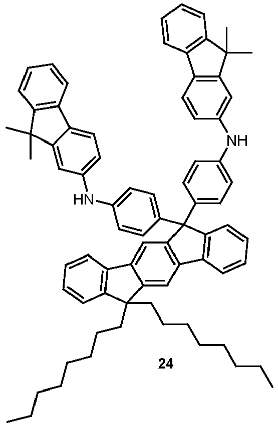

Die Verbindung **24** wird wie folgt hergestellt:

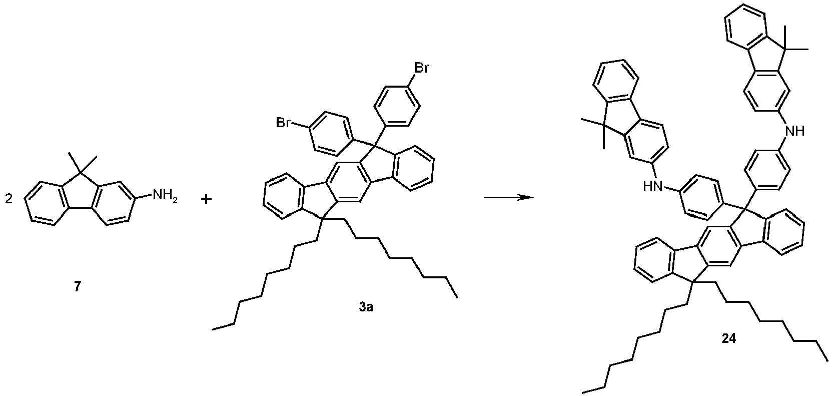

13,9 g 4-Aminodimethylfluoren 7 (66 mmol), 25,2 g (32 mmol) Dibrom 3a und 9,4 g Natrium-tert-Butylat (97 mmol) werden in Toluol gelöst und die Reaktionslösung sorgfällig entgast. Die Reaktionslösung wird auf 80°C erwärmt und die Reaktion durch Zugabe des Katalysators 148 mg (0,16 mmol) Pd₂dba₃ und 201 mg (0,32 mmol) BINAP gestartet und auf Rückflusstemperatur erhitzt. Der Fortschritt der Reaktion wird mittels Dünnschichtchromatographie verfolgt. Nach Beendigung der Reaktion wird auf Raumtemperatur abgekühlt und mit 30 ml Wasser versetzt. Es werden die Phasen getrennt, die wässrige wird zweimal mit 30 ml Toluol extrahiert. Die vereinigten organischen Phasen werden dreimal mit 30 ml Wasser gewaschen, über Magnesiumsulfat getrocknet, und das Lösungsmittel im Vakuum abgezogen. Das Rohprodukt wird aus Ethanol umkristallisiert.

### B) Herstellung der Polymere

### Beispiele 11 bis 16: Herstellung der Polymere (P1 bis P5) sowie des Vergleichspolymeren (V1)

### Standard Prozedur:

2 mmol eines halogenierten Monomers und 2 mmol eines Diaminmonomers, sowie 0,577 g (6 mmol) Natrium-*tert*.-butanolat werden in 20 ml Toluol gelöst. Die erhaltene Reaktionslösung wird unter Argon sorgfällig entgast. Die Lösung wird unter Schutzgasatmosphäre auf ca. 80°C erwärmt und die Reaktion durch Zugabe von 3,6 mg (16 µmol) Palladiumacetat und 69 mg (96 µmol) Tri-*tert*.-butylphosphin gelöst in 1 ml Toluol gestartet. Die Reaktionsmischung wird für ca. 1 Stunde zum Sieden erhitzt bis die Lösung viskos wird. Die Polymerisation wird durch die Zugabe von 3 mg Brombiphenyl gestoppt, und die Reaktionslösung für eine weitere Stunde zum Sieden erhitzt um die Endgruppen zu terminieren. Die Lösung wird auf 65°C abgekühlt und mit 80 ml Toluol verdünnt und mit 80 ml einer 10%igen Thiocarbamidlösung versetzt und für 3 Stunden bei 65°C gerührt. Die Mischung wird auf Raumtemperatur abgekühlt und dreimal mit 50 ml Wasser extrahiert und anschließend in der doppelten Menge Methanol gefällt. Zur Reinigung wird das Polymer in Toluol gelöst und anschließend in der doppelten Menge Methanol gefällt. Diese Prozedur wird ein weiteres Mal wiederholt.

### Beispiel 11 (Polymer P1)

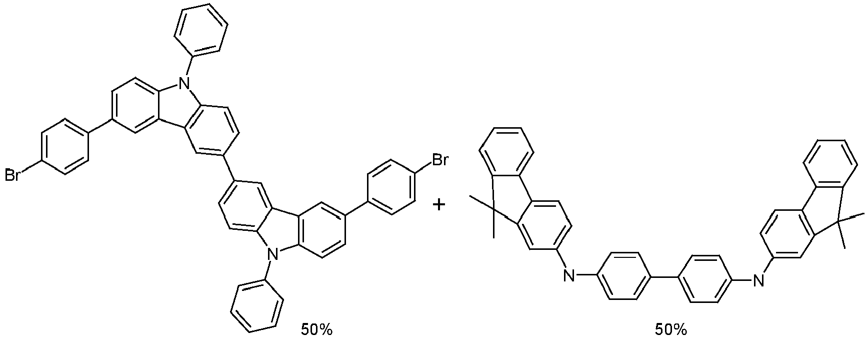

### Beispiel 12 (Polymer P2)

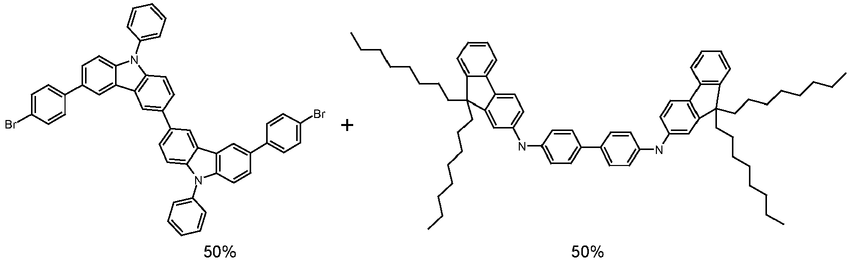

### Beispiel 13 (Polymer P3)

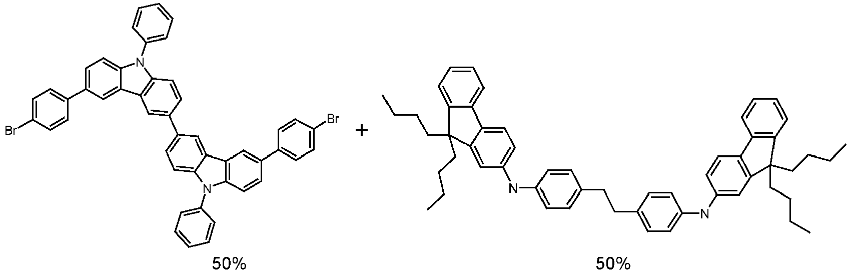

### Beispiel 14 (Polymer P4)

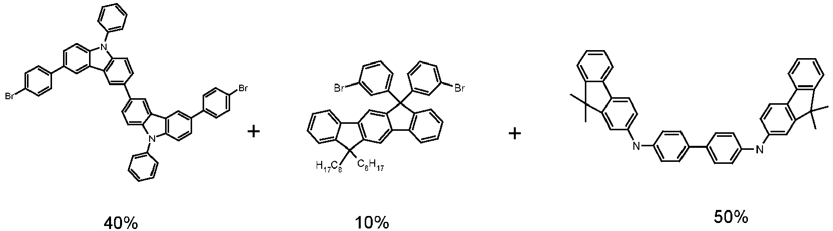

### Beispiel 15 (Polymer P5)

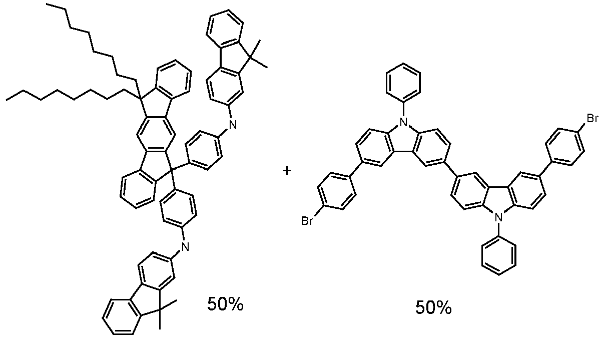

### Vergleichsbeispiel 16 (Vergleichspolymer V1)

Die Herstellung von Vergleichspolymer V1 durch SUZUKI-Kupplung erfolgt gemäß dem in der WO 03/048225 beschriebenen Verfahren.

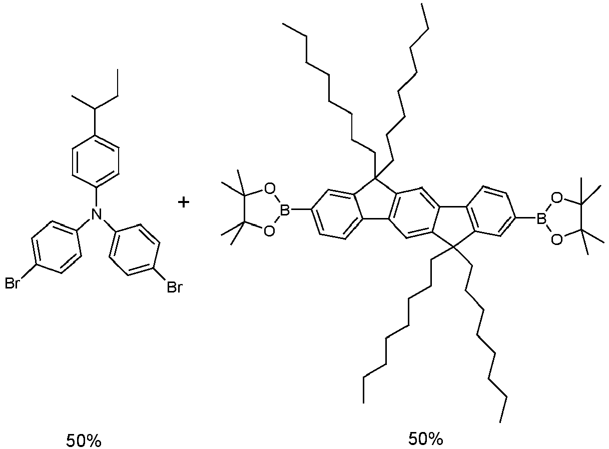

### C) Herstellung von PLEDs

### Beispiele 17 bis 28:

Die Herstellung einer polymeren organischen Leuchtdiode (PLED) ist in der Literatur bereits vielfach beschrieben (z.B. in der WO 2004/037887 A2). Um die vorliegende Erfindung beispielhaft zu erläutern, werden PLEDs mit den Polymeren P1 bis P5 sowie dem Vergleichspolymer V1 durch Spincoating hergestellt.

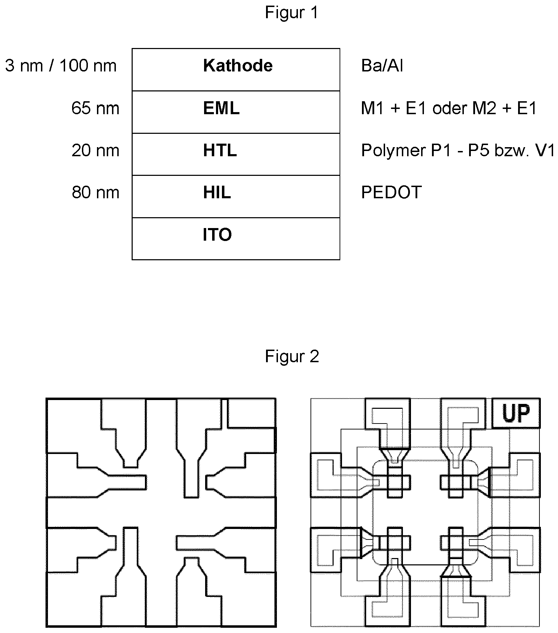

Eine typische Device hat den in Figur 1 dargestellten Aufbau, wobei die Polymere die Funktion einer Lochtransportschicht (Hole-Transport-Layer; HTL) erfüllen. Eine während des Herstellungs-prozesses aufgedampfte Kathode weist 4 Pixel à 2 x 2 mm auf. In Aufsicht ist der Aufbau der Vorrichtung in Figur 2 dargestellt.

Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 80 nm Schicht PEDOT (PEDOT ist ein Polythiophen-Derivat (Baytron P VAI 4083sp.) von H.C. Starck, Goslar, das als wässrige Dispersion geliefert wird) durch Spin-Coating aufgebracht. Die benötigte Spinrate hängt vom Verdünnungsgrad und der spezifischen Spincoater-Geometrie ab (typisch für 80 nm: 4500 rpm). Um Restwasser aus der Schicht zu entfernen, werden die Substrate für 10 Minuten bei 180°C auf einer Heizplatte ausgeheizt.

Danach werden unter Inertgasatmosphäre (Stickstoff bzw. Argon) zunächst 20 nm einer Interlayer oder HTL-Schicht aufgebracht. Die Polymere werden in dieser Schicht aus einer toluolischen Lösung mit einer Konzentration zwischen 5 und 8 g/l verarbeitet. Anschließend werden dann 65 nm der emittierenden Schicht aus Toluollösungen aufgebracht. Beide Schichten werden bei 180°C mindestens 10 Minuten ausgeheizt.

Abschließend wird die Ba/Al-Kathode im angegebenen Muster durch eine Aufdampfmaske aufgedampft (hochreine Metalle von Aldrich, besonders Barium 99,99 % (Best-Nr. 474711); Aufdampfanlagen von Lesker o.a., typischer Vakuumlevel 5 × 10⁻⁶ mbar; Schichtdicke Ba/Al 3 nm/100 nm). Um vor allem die Kathode vor Luft und Luftfeuchtigkeit zu schützen, wird die Device abschließend verkapselt und dann charakterisiert.

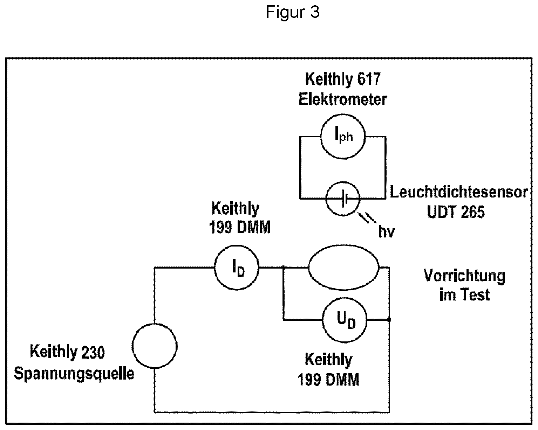

Dazu werden die Devices in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen. Der typische Messaufbau ist in Figur 3 dargestellt.

Typischerweise werden die Spannungen von 0 bis max. 20 V in 0,2 V-Schritten erhöht und wieder erniedrigt. Für jeden Messpunkt wird der Strom durch die Device sowie der erhaltene Photostrom von der Photodiode gemessen. Auf diese Art und Weise erhält man die IVL-Daten der Testdevices. Wichtige Kenngrößen sind die gemessene maximale Effizienz ("Max. Eff." in cd/A) und die für 100 cd/m² benötigte Spannung.

Um außerdem die Farbe und das genaue Elektrolumineszenzspektrum der Testdevices zu kennen, wird nach der ersten Messung nochmals die für 100 cd/m² benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'eclairage, Normalbetrachter von 1931) abgeleitet werden.

Die Ergebnisse, die bei Verwendung der Polymeren P1 bis P5 sowie V1 als Interlayer in PLEDs erhalten werden, sind in Tabelle 1 zusammen-gefasst. Als emittierende Schichten EML1 (M1 und E1) und EML2 (M2 und E1) werden die im Folgenden dargestellten Kombinationen aus löslich Matrices und Emitter verwendet. Der Emitter E1 wird der Matrix M1 bzw. M2 in einer Konzentration von 20 Gew.-% beigemischt.

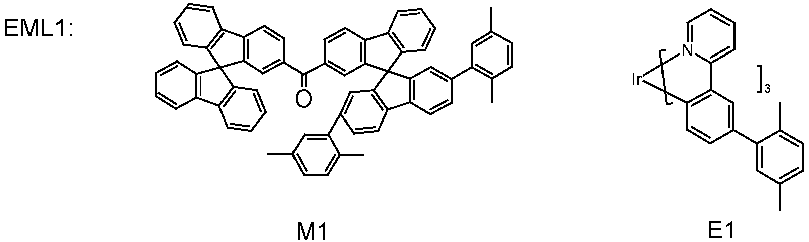

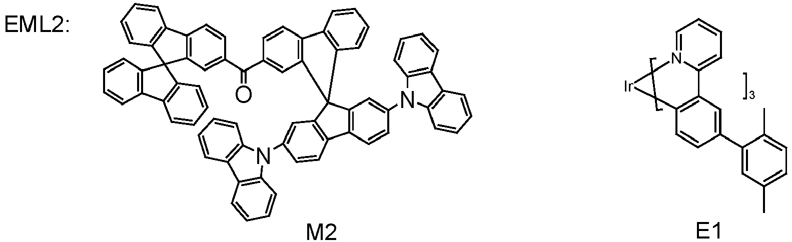

**Tabelle 1 Device Beispiele für die Polymere P1 bis P5 (Beispiele 17 bis 21 sowie 23 bis 27) sowie das Vergleichspolymer V1 (Beispiele 22 und 28).**

| Bsp. | Interlayer | Matrix | Max. Eff. [cd/A] | Max. Eff. [lm/W] | U @ 1000 cd/m² [V] | CIE [x/y] |
|---|---|---|---|---|---|---|
| 17 | P1 | EML1 | 25,5 | 19,0 | 4,2 | 0,34/0,62 |
| 18 | P2 | EML1 | 26,2 | 19,4 | 4,1 | 0,34/0,62 |
| 19 | P3 | EML1 | 40,4 | 27,7 | 4,6 | 0,34/0,62 |
| 20 | P4 | EML1 | 39,6 | 27,2 | 4,5 | 0,34/0,62 |
| 21 | P5 | EML1 | 43,2 | 30,1 | 4,0 | 0,34/0,62 |
| 22 | V1 | EML1 | 27,1 | 15,3 | 5,5 | 0,34/0,62 |
| 23 | P1 | EML2 | 28,8 | 21,8 | 4,1 | 0,33/0,62 |
| 24 | P2 | EML2 | 28,3 | 21,5 | 4,0 | 0,33/0,62 |
| 25 | P3 | EML2 | 31,7 | 23,6 | 4,2 | 0,33/0,62 |
| 26 | P4 | EML2 | 33,5 | 24,1 | 4,3 | 0,33/0,62 |
| 27 | P5 | EML2 | 42,0 | 31,3 | 4,1 | 0,33/0,62 |
| 28 | V1 | EML2 | 28,5 | 17,3 | 5,2 | 0,33/0,62 |

Die Polymere P1 bis P5 zeigen gegenüber dem Vergleichs-polymer V1, wie aus den Ergebnissen in Tabelle 1 ersichtlich, einen enormen Vorteil in Bezug auf die zum Betrieb der Device benötigten Spannung und der Lichteffizienz. Der Gewinn an Betriebsspannung für eine Helligkeit von 1000 cd/m² kann bis zu 1,5 V betragen. Die Vorteile der Polymere P1 bis P5 werden weiterhin bei Betrachtung der Leistungseffizienz deutlich. Die Effizienz kann durch Verwendung eines Polymers P1 bis P5 annähernd verdoppelt werden.

## Patentansprüche

1. Elektronische Vorrichtung enthaltend ein Polymer, welches mindestens eine Carbazol-Struktureinheit der allgemeinen Formel (la) enthält 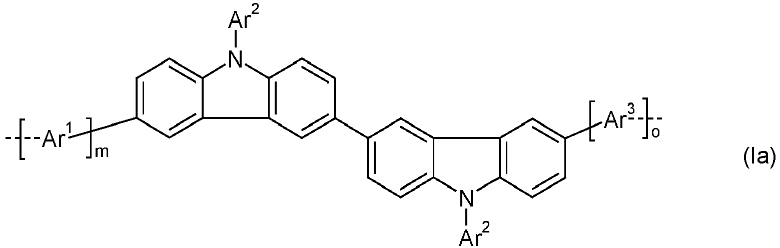 wobei
Ar¹, Ar², Ar³ jeweils unabhängig voneinander eine Aryl- oder Heteroarylgruppe ist, welche mit einem oder mehreren beliebigen Resten R substituiert sein kann;
m, o unabhängig voneinander 0 oder 1 ist; und
die gestrichelten Linien die Verknüpfung im Polymer darstellen;
und mindestens eine Arylamin-Struktureinheit der allgemeinen Formel (II) und/oder (III) 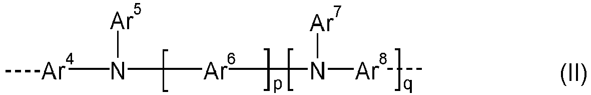 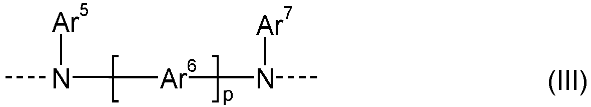 wobei
Ar⁴, Ar⁵, Ar⁷, Ar⁸ jeweils unabhängig voneinander eine Aryl- oder Heteroarylgruppe ist, welche mit einem oder mehreren beliebigen Resten R substituiert sein kann;
Ar⁶ eine Aryl- oder Heteroarylgruppe ist, welche mit einem oder mehreren beliebigen Resten R substituiert sein kann oder eine Gruppe der Formel Ar⁹-Y-Ar⁹ darstellt, wobei Ar⁹ jeweils unabhängig eine Aryl- oder Heteroarylgruppe ist, welche mit einem oder mehreren beliebigen Resten R substituiert ist oder welche miteinander verknüpft sein können, und Y eine Abstandsgruppe oder eine direkte Bindung ist;
p 1, 2 oder 3 ist;
q 0 oder 1 ist und
die gestrichelten Linien die Verknüpfung im Polymer darstellen, **dadurch gekennzeichnet, dass** das Polymer in der Vorrichtung als Bestandteil der Lochtransport- oder Lochinjektionsschicht vorliegt.

2. Elektronische Vorrichtung nach Anspruch 1, **dadurch gekennzeichnet, dass** das Polymer mindestens eine Carbazol-Struktureinheit der allgemeinen Formel (Ib) enthält 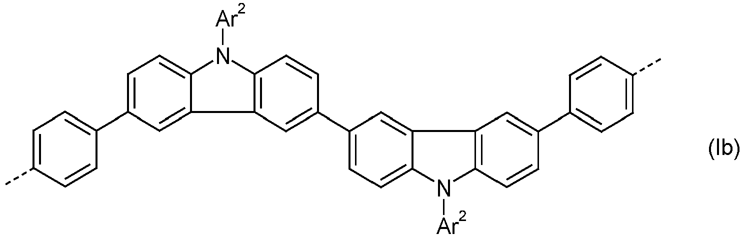 wobei Ar² und die gestrichelten Linien die in Anspruch 1 angegebene Bedeutung haben.

3. Elektronische Vorrichtung nach Anspruch 1 oder 2, **dadurch gekennzeichnet, dass** das Polymer mindestens eine Arylamin-Struktureinheit der allgemeinen Formel (IIa) und/oder (IIIa) enthält 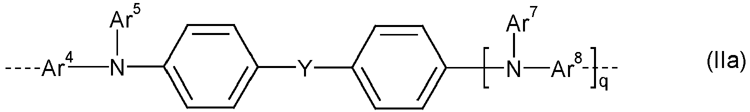 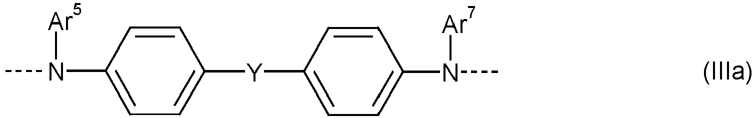
wobei Y eine Abstandsgruppe oder eine direkte Bindung ist und
Ar⁴, Ar⁵, Ar⁷, Ar⁸, q und die gestrichelten Linien die in Anspruch 1 angegebene Bedeutung haben.

4. Elektronische Vorrichtung nach Anspruch 3, **dadurch gekennzeichnet, dass** das Polymer mindestens eine Arylamin-Struktureinheit der allgemeinen Formel (IIIb) enthält 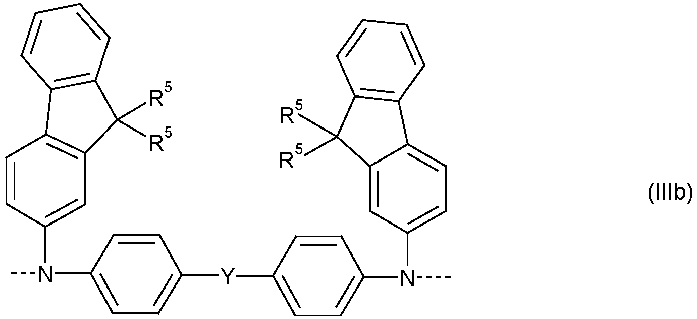 wobei
Y eine Abstandsgruppe oder eine direkte Bindung ist;
R⁵ jeweils unabhängig voneinander ein Wasserstoffatom, eine geradkettige Alkyl-, Alkoxy- oder Thioalkoxygruppe mit 1 bis 40 C-Atomen oder eine verzweigte oder cyclische Alkyl-, Alkoxy-oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R⁵ ein mono- oder polycyclisches, aliphatisches oder aromatisches Ringsystem miteinander und/oder mit dem Ring, an dem die Gruppe R⁵ gebunden ist, bilden können, und
die gestrichelten Linien die Verknüpfung im Polymer darstellen.

5. Elektronische Vorrichtung nach einem oder mehreren der Ansprüche 1 bis 4, **dadurch gekennzeichnet, dass** R bei jedem Auftreten unabhängig voneinander ausgewählt ist aus F, Cl, Br, I, N(Ar)₂, N(R')₂, CN, NO₂, Si(R')₃, B(OR')₂, C(=O)Ar, C(=O)R', P(=O)(Ar)₂, P(=O)(R')₂, S(=O)Ar, S(=O)R', S(=O)₂Ar, S(=O)₂R', -CR'=CR'Ar, OSO₂R', einer geradkettigen Alkyl-, Alkoxy- oder Thioalkoxygruppe mit 1 bis 40 C-Atomen oder einer verzweigten oder cyclischen Alkyl-, Alkoxy- oder Thioalkoxygruppe mit 3 bis 40 C-Atomen, die jeweils mit einem oder mehreren Resten R' substituiert sein kann, wobei eine oder mehrere nicht benachbarte CH₂-Gruppen durch R'C=CR', C=C, Si(R')₂, Ge(R')₂, Sn(R')₂, C=O, C=S, C=Se, C=NR', P(=O)(R'), SO, SO₂, NR', O, S oder CONR' ersetzt sein können und wobei ein oder mehrere H-Atome durch F, Cl, Br, I, CN oder NO₂ ersetzt sein können, einer vernetzbaren Gruppe oder einem aromatischen oder heteroaromatischen Ringsystem mit 5 bis 60 Ringatomen, das jeweils durch einen oder mehrere Reste R' substituiert sein kann, oder einer Aryloxy- oder Heteroaryloxygruppe mit 5 bis 60 Ringatomen, die durch einen oder mehrere Reste R' substituiert sein kann, oder einer Kombination dieser Systeme, wobei zwei oder mehrere Substituenten R auch miteinander ein mono- oder polycyclisches, aliphatisches oder aromatisches Ringsystem bilden können, wobei R' jeweils unabhängig voneinander H oder ein aliphatischer oder aromatischer Kohlenwasserstoffrest mit 1 bis 20 C-Atomen und Ar eine Aryl- oder Heteroarylgruppe mit 2 bis 30 C-Atomen ist.

6. Elektronische Vorrichtung nach einem oder mehreren der Ansprüche 1 bis 5, **dadurch gekennzeichnet, dass** das Polymer mindestens eine Verbindungsstruktureinheit enthält.

7. Elektronische Vorrichtung nach Anspruch 6, **dadurch gekennzeichnet, dass** das Polymer mindestens eine Verbindungsstruktureinheit der Formel (IV) enthält 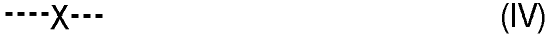 wobei X eine Abstandsgruppe ist und die gestrichelten Linien die Verknüpfung im Polymer darstellen.

8. Elektronische Vorrichtung nach Anspruch 6, **dadurch gekennzeichnet, dass** das Polymer mindestens eine Verbindungsstruktureinheit der Formel (Va) enthält 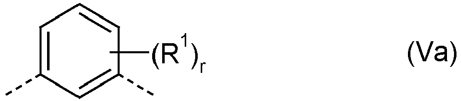 wobei
R¹ eine geradkettige Alkyl-, Alkoxy- oder Thioalkoxygruppe mit 1 bis 40 C-Atomen oder eine verzweigte oder cyclische Alkyl-, Alkoxy-oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ ein mono- oder polycyclisches, aliphatisches oder aromatisches Ringsystem miteinander und/oder mit dem Ring, an dem die Gruppe R¹ gebunden ist, bilden können;
r 0, 1, 2, 3 oder 4 ist und
die gestrichelten Linien die Verknüpfung im Polymer darstellen.

9. Elektronische Vorrichtung nach Anspruch 6, **dadurch gekennzeichnet, dass** das Polymer mindestens eine Verbindungsstruktureinheit der Formel (Vb) enthält 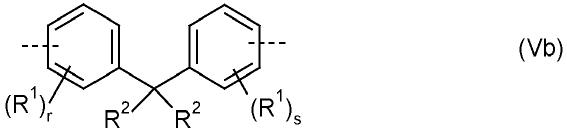 wobei
R¹, R² jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono-oder polycyclisches, aliphatisches oder aromatisches Ring-system miteinander und/oder mit dem Ring, an dem die Gruppe R¹ gebunden ist, bilden können;
r, s unabhängig voneinander 0, 1, 2, 3 oder 4 ist und
die gestrichelten Linien die Verknüpfung im Polymer darstellen.

10. Elektronische Vorrichtung nach Anspruch 9, **dadurch gekennzeichnet, dass** das Polymer mindestens eine Verbindungsstruktureinheit der Formel (Vb1) enthält 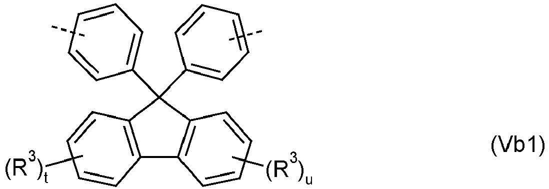 wobei
R³ jeweils unabhängig voneinander eine geradkettige Alkyl-, Alkoxy-oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R³ ein mono- oder polycyclisches, aliphatisches oder aromatisches Ringsystem miteinander und/oder mit dem Ring, an dem die Gruppe R³ gebunden ist, bilden können;
t, u unabhängig voneinander 0, 1, 2, 3 oder 4 ist und
die gestrichelten Linien die Verknüpfung im Polymer darstellen.

11. Elektronische Vorrichtung nach Anspruch 10, **dadurch gekennzeichnet, dass** das Polymer mindestens eine Verbindungsstruktureinheit der Formel (Vb2) enthält 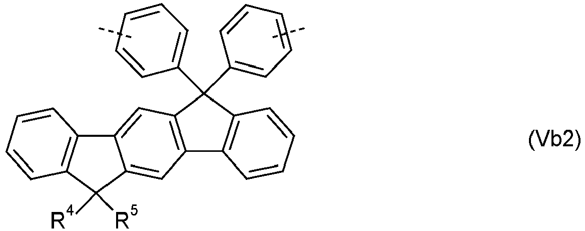 wobei
R⁴, R⁵ jeweils unabhängig voneinander eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanatgruppe oder eine Thioisocyanatgruppe, eine Aminogruppe, eine Hydroxygruppe, eine Nitrogruppe, eine CF₃-Gruppe, Cl, Br, F, eine vernetzbare Gruppe oder ein substituiertes oder unsubstituiertes, aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R⁴, R⁵ ein mono- oder polycyclisches, aliphatisches oder aromatisches Ringsystem miteinander und/oder mit dem Ring, an dem die Gruppe R⁴ oder R⁵ gebunden ist, bilden können und
die gestrichelten Linien die Verknüpfung im Polymer darstellen.

12. Elektronische Vorrichtung nach einem oder mehreren der Ansprüche 1 bis 11, **dadurch gekennzeichnet, dass** sie eine organische elektrolumineszierende Vorrichtung (OLED), eine polymere elektrolumineszierende Vorrichtung (PLED), eine organische integrierte Schaltung (O-IC), ein organischer Feld-Effekt-Transistor (O-FET), ein organischer Dünnfilmtransistor (O-TFT), ein organischer lichtemittierender Transistor (O-LET), eine organische Solarzelle (O-SC), ein organischer optischer Detektor, ein organischer Photorezeptor, ein organisches Feld-Quench-Device (O-FQD), eine lichtemittierende elektrochemische Zelle (LEC) oder eine organische Laserdiode (O-Laser) ist.

## Claims

1. Electronic device containing a polymer which contains at least one carbazole structural unit of the general formula (Ia) 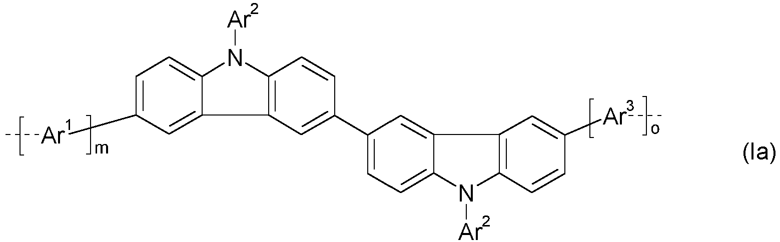 where
Ar¹, Ar², Ar³ in each case, independently of one another, are an aryl or heteroaryl group, which may be substituted by one or more radicals R of any desired type;
m, o, independently of one another, are 0 or 1, and
the dashed lines represent the linking in the polymer;
and at least one arylamine structural unit of the general formula (II) and/or (III) 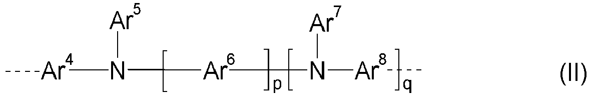 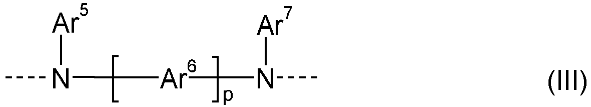 where
Ar⁴, Ar⁵, Ar⁷, Ar⁸ in each case, independently of one another, are an aryl or heteroaryl group, which may be substituted by one or more radicals R of any desired type;
Ar⁶ is an aryl or heteroaryl group, which may be substituted by one or more radicals R of any desired type or represents a group of the formula Ar⁹-Y-Ar⁹, where Ar⁹ in each case independently is an aryl or heteroaryl group, which is substituted by one or more radicals R of any desired type or which may be linked to one another, and Y is a spacer group or a direct bond;
p is 1, 2 or 3;
q is 0 or 1 and
the dashed lines represent the linking in the polymer,
**characterised in that** the polymer is present in the device as a constituent of the hole-transport or hole-injection layer.

2. Electronic device according to Claim 1, **characterised in that** the polymer contains at least one carbazole structural unit of the general formula (Ib) 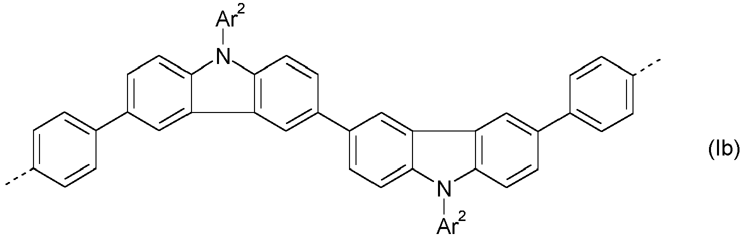 where Ar² and the dashed lines have the meaning indicated in Claim 1.

3. Electronic device according to Claim 1 or 2, **characterised in that** the polymer contains at least one arylamine structural unit of the general formula (IIa) and/or (IIIa) 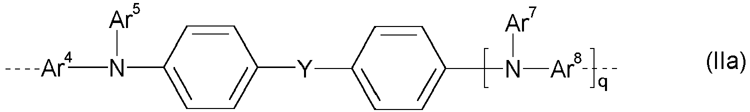 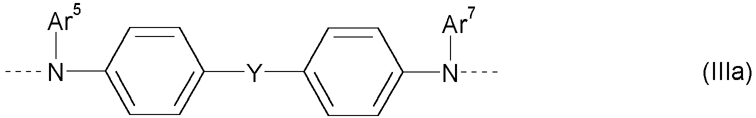
where Y is a spacer group or a direct bond and
Ar⁴, Ar⁵, Ar⁷, Ar⁸, q and the dashed lines have the meaning indicated in Claim 1.

4. Electronic device according to Claim 3, **characterised in that** the polymer contains at least one arylamine structural unit of the general formula (IIIb) 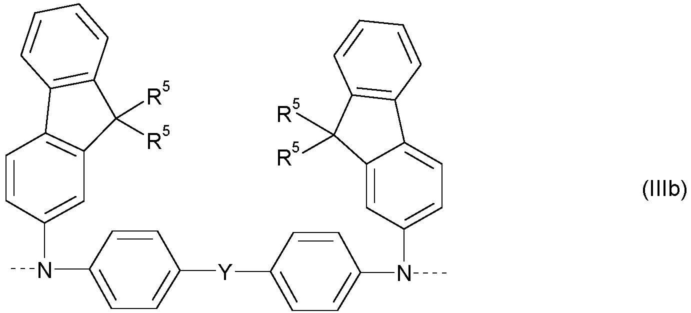 where
Y is a spacer group or a direct bond;
R⁵ in each case, independently of one another, is a hydrogen atom, a straight-chain alkyl, alkoxy or thioalkoxy group having 1 to 40 C atoms or a branched or cyclic alkyl, alkoxy or thioalkoxy group having 3 to 40 C atoms or is a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a halo-formyl group (-C(=O)-X, in which X represents a halogen atom), a formyl group (-C(=O)-H), an isocyano group, an isocyanate group, a thiocyanate group or a thioisocyanate group, an amino group, a hydroxyl group, a nitro group, a CF₃ group, CI, Br, F, a crosslinkable group or a substituted or unsubstituted, aromatic or heteroaromatic ring system having 5 to 60 ring atoms, or an aryloxy or heteroaryloxy group having 5 to 60 ring atoms, or a combination of these systems, where one or more of the groups R⁵ may form a mono- or polycyclic, aliphatic or aromatic ring system with one another and/or with the ring to which the group R⁵ is bonded, and
the dashed lines represent the linking in the polymer.

5. Electronic device according to one or more of Claims 1 to 4, **characterised in that** R is selected on each occurrence, independently of one another, from F, CI, Br, I, N(Ar)₂, N(R')₂, CN, NO₂, Si(R')₃, B(OR')₂, C(=O)Ar, C(=O)R', P(=O)(Ar)₂, P(=O)(R')₂, S(=O)Ar, S(=O)R', S(=O)₂Ar, S(=O)₂R', -CR'=CR'Ar, OSO₂R', a straight-chain alkyl, alkoxy or thioalkoxy group having 1 to 40 C atoms or a branched or cyclic alkyl, alkoxy or thioalkoxy group having 3 to 40 C atoms, which may in each case be substituted by one or more radicals R', where one or more non-adjacent CH₂ groups may be replaced by R'C=CR', C=C, Si(R')₂, Ge(R')₂, Sn(R')₂, C=O, C=S, C=Se, C=NR', P(=O)(R'), SO, SO₂, NR', O, S or CONR' and where one or more H atoms may be replaced by F, CI, Br, I, CN or NO₂, a crosslinkable group or an aromatic or heteroaromatic ring system having 5 to 60 ring atoms, which may in each case be substituted by one or more radicals R', or an aryloxy or heteroaryloxy group having 5 to 60 ring atoms, which may be substituted by one or more radicals R', or a combination of these systems, where two or more substituents R may also form a mono- or polycyclic, aliphatic or aromatic ring system with one another, where R' in each case, independently of one another, is H or an aliphatic or aromatic hydrocarbon radical having 1 to 20 C atoms and Ar is an aryl or heteroaryl group having 2 to 30 C atoms.

6. Electronic device according to one or more of Claims 1 to 5, **characterised in that** the polymer contains at least one connecting structural unit.

7. Electronic device according to Claim 6, **characterised in that** the polymer contains at least one connecting structural unit of the formula (IV) 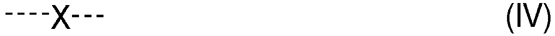 where X is a spacer group and the dashed lines represent the linking in the polymer.

8. Electronic device according to Claim 6, **characterised in that** the polymer contains at least one connecting structural unit of the formula (Va) 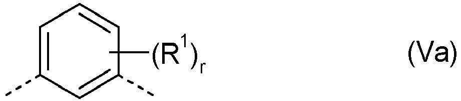 where
R¹ is a straight-chain alkyl, alkoxy or thioalkoxy group having 1 to 40 C atoms or a branched or cyclic alkyl, alkoxy or thioalkoxy group having 3 to 40 C atoms or is a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a halo-formyl group (-C(=O)-X, in which X represents a halogen atom), a formyl group (-C(=O)-H), an isocyano group, an isocyanate group, a thiocyanate group or a thioisocyanate group, an amino group, a hydroxyl group, a nitro group, a CF₃ group, CI, Br, F, a crosslinkable group or a substituted or unsubstituted, aromatic or heteroaromatic ring system having 5 to 60 ring atoms, or an aryloxy or heteroaryloxy group having 5 to 60 ring atoms, or a combination of these systems, where one or more of the groups R¹ may form a mono- or polycyclic, aliphatic or aromatic ring system with one another and/or with the ring to which the group R¹ is bonded;
r is 0, 1, 2, 3 or 4 and
the dashed lines represent the linking in the polymer.

9. Electronic device according to Claim 6, **characterised in that** the polymer contains at least one connecting structural unit of the formula (Vb) 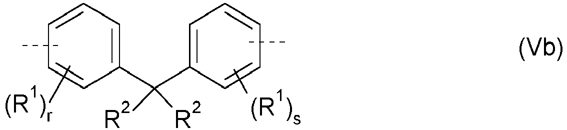 where
R¹, R² in each case, independently of one another, are a straightchain alkyl, alkoxy or thioalkoxy group having 1 to 40 C atoms or a branched or cyclic alkyl, alkoxy or thioalkoxy group having 3 to 40 C atoms or are a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a halo-formyl group (-C(=O)-X, in which X represents a halogen atom), a formyl group (-C(=O)-H), an isocyano group, an isocyanate group, a thiocyanate group or a thioisocyanate group, an amino group, a hydroxyl group, a nitro group, a CF₃ group, Cl, Br, F, a crosslinkable group or a substituted or unsubstituted, aromatic or heteroaromatic ring system having 5 to 60 ring atoms, or an aryloxy or heteroaryloxy group having 5 to 60 ring atoms, or a combination of these systems, where one or more of the groups R¹ and/or R² may form a mono- or polycyclic, aliphatic or aromatic ring system with one another and/or with the ring to which the group R¹ is bonded;
r, s, independently of one another, are 0, 1, 2, 3 or 4 and
the dashed lines represent the linking in the polymer.

10. Electronic device according to Claim 9, **characterised in that** the polymer contains at least one connecting structural unit of the formula (Vb1) 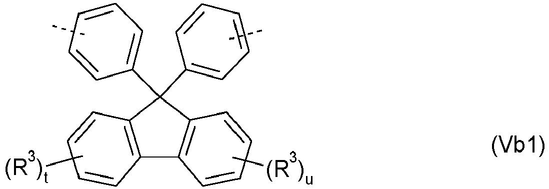 where
R³ in each case, independently of one another, is a straight-chain alkyl, alkoxy or thioalkoxy group having 1 to 40 C atoms or a branched or cyclic alkyl, alkoxy or thioalkoxy group having 3 to 40 C atoms or is a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a halo-formyl group (-C(=O)-X, in which X represents a halogen atom), a formyl group (-C(=O)-H), an isocyano group, an isocyanate group, a thiocyanate group or a thioisocyanate group, an amino group, a hydroxyl group, a nitro group, a CF₃ group, Cl, Br, F, a crosslinkable group or a substituted or unsubstituted, aromatic or heteroaromatic ring system having 5 to 60 ring atoms, or an aryloxy or heteroaryloxy group having 5 to 60 ring atoms, or a combination of these systems, where one or more of the groups R³ may form a mono- or polycyclic, aliphatic or aromatic ring system with one another and/or with the ring to which the group R³ is bonded;
t, u, independently of one another, are 0, 1, 2, 3 or 4 and
the dashed lines represent the linking in the polymer.

11. Electronic device according to Claim 10, **characterised in that** the polymer contains at least one connecting structural unit of the formula (Vb2) 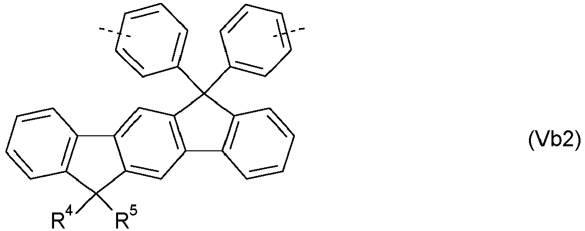 where
R⁴, R⁵ in each case, independently of one another, are a straightchain alkyl, alkoxy or thioalkoxy group having 1 to 40 C atoms or a branched or cyclic alkyl, alkoxy or thioalkoxy group having 3 to 40 C atoms or are a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a halo-formyl group (-C(=O)-X, in which X represents a halogen atom), a formyl group (-C(=O)-H), an isocyano group, an isocyanate group, a thiocyanate group or a thioisocyanate group, an amino group, a hydroxyl group, a nitro group, a CF₃ group, Cl, Br, F, a crosslinkable group or a substituted or unsubstituted, aromatic or heteroaromatic ring system having 5 to 60 ring atoms, or an aryloxy or heteroaryloxy group having 5 to 60 ring atoms, or a combination of these systems, where one or more of the groups R⁴, R⁵ may form a mono- or polycyclic, aliphatic or aromatic ring system with one another and/or with the ring to which the group R⁴ or R⁵ is bonded, and
the dashed lines represent the linking in the polymer.

12. Electronic device according to one or more of Claims 1 to 11, **characterised in that** it is an organic electroluminescent device (OLED), a polymeric electroluminescent device (PLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organic photoreceptor, an organic field-quench device (O-FQD), a light-emitting electrochemical cell (LEC) or an organic laser diode (O-laser).

## Revendications

1. Dispositif électronique contenant un polymère qui contient au moins une unité structurelle carbazole de la formule générale (la) 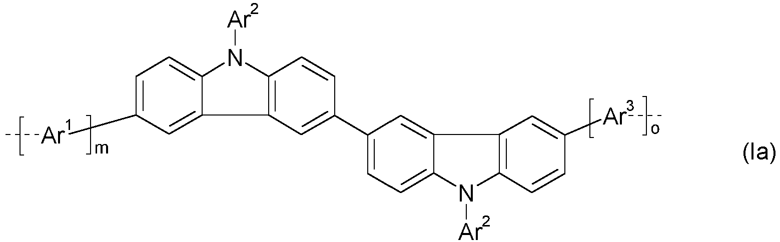 dans laquelle
Ar¹, Ar², Ar³ sont dans chaque cas, de manière indépendante les uns des autres, un groupe aryle ou hétéroaryle, lequel peut être substitué par un radical ou par plusieurs radicaux R de n'importe quel type souhaité ;
m, o sont, de manière indépendante l'un de l'autre, 0 ou 1, et
les lignes en pointillés représentent la liaison dans le polymère ;
et au moins une unité structurelle arylamine des/de la formule(s) générale(s) (II) et/ou (III) 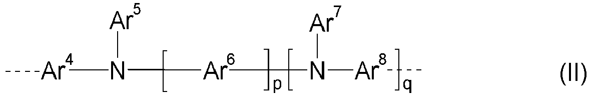 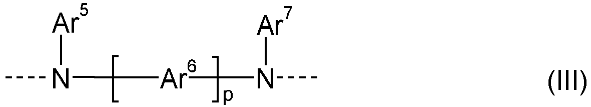 dans lesquelles
Ar⁴, Ar⁵, Ar⁷, Ar⁸ sont dans chaque cas, de manière indépendante les uns des autres, un groupe aryle ou hétéroaryle, lequel peut être substitué par un radical ou par plusieurs radicaux R de n'importe quel type souhaité ;
Ar⁶ est un groupe aryle ou hétéroaryle, lequel peut être substitué par un radical ou par plusieurs radicaux R de n'importe quel type souhaité, ou représente un groupe de la formule Ar⁹-Y-Ar⁹, où Ar⁹ est dans chaque cas de manière indépendante un groupe aryle ou hétéroaryle, lequel peut être substitué par un radical ou par plusieurs radicaux R de n'importe quel type souhaité ou lesquels peuvent être liés les uns aux autres, et Y est un groupe d'espaceur ou une liaison directe ;
p est 1, 2 ou 3 ;
q est 0 ou 1 et
les lignes en pointillés représentent la liaison dans le polymère, **caractérisé en ce que** le polymère est présent dans le dispositif en tant que constituant de la couche de transport de trous ou d'injection de trous.

2. Dispositif électronique selon la revendication 1, **caractérisé en ce que** le polymère contient au moins une unité structurelle carbazole de la formule générale (Ib) 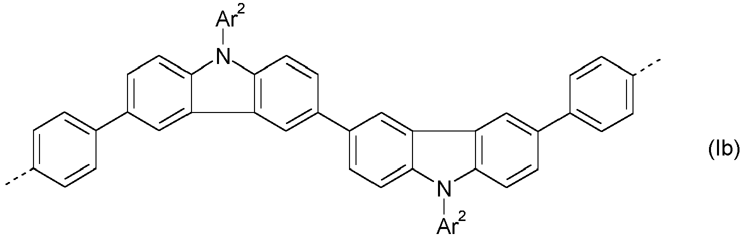 dans laquelle Ar² et les lignes en pointillés présentent la signification qui a été indiquée selon la revendication 1.

3. Dispositif électronique selon la revendication 1 ou 2, **caractérisé en ce que** le polymère contient au moins une unité structurelle arylamine des/de la formule(s) générale(s) (IIa) et/ou (IIIa) 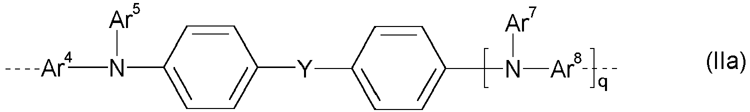 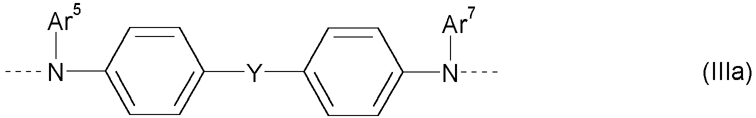 dans lesquelles Y est un groupe d'espaceur ou une liaison directe et Ar⁴, Ar⁵, Ar⁷, Ar⁸, q et les lignes en pointillés présentent la signification qui a été indiquée selon la revendication 1.

4. Dispositif électronique selon la revendication 3, **caractérisé en ce que** le polymère contient au moins une unité structurelle arylamine de la formule générale (IIIb) 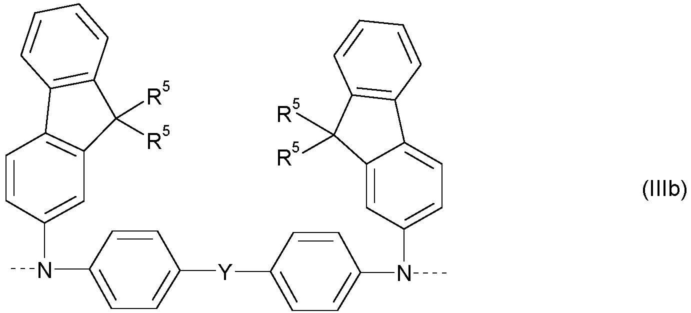 dans laquelle
Y est un groupe d'espaceur ou une liaison directe ;
R⁵ est dans chaque cas, de manière indépendante les uns des autres, un atome d'hydrogène, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C ou est un groupe silyle ou un groupe céto substitué qui comporte de 1 à 40 atome(s) de C, un groupe alcoxycarbonyle qui comporte de 2 à 40 atomes de C, un groupe aryloxycarbonyle qui comporte de 7 à 40 atomes de C, un groupe cyano (-CN), un groupe carbamoyle (-C(=O)NH₂), un groupe haloformyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe amino, un groupe hydroxyle, un groupe nitro, un groupe CF₃, Cl, Br, F, un groupe réticulable ou un système de cycle aromatique ou hétéroaromatique substitué ou non substitué qui comporte de 5 à 60 atomes de cycle, ou un groupe aryloxy ou hétéroaryloxy qui comporte de 5 à 60 atomes de cycle, ou une combinaison de ces systèmes, où un ou plusieurs des groupes R⁵ peut/peuvent former un système de cycle aliphatique ou aromatique mono- ou polycyclique les uns avec les autres et/ou avec le cycle auquel le groupe R⁵ est lié, et les lignes en pointillés représentent la liaison dans le polymère.

5. Dispositif électronique selon une ou plusieurs des revendications 1 à 4, **caractérisé en ce que** R est sélectionné pour chaque occurrence, de manière indépendante les unes des autres, parmi F, Cl, Br, I, N(Ar)₂, N(R')₂, CN, NO₂, Si(R')₃, B(OR')₂, C(=O)Ar, C(=O)R', P(=O)(Ar)₂, P(=O)(R')₂, S(=O)Ar, S(=O)R', S(=O)₂Ar, S(=O)₂R', -CR'=CR'Ar, OSO₂R', un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C, lequel peut dans chaque cas être substitué par un radical ou par plusieurs radicaux R', où un ou plusieurs groupe(s) CH₂ non adjacents peut/peuvent être remplacé(s) par R'C=CR', C=C, Si(R')₂, Ge(R')₂, Sn(R')₂, C=O, C=S, C=Se, C=NR', P(=O)(R'), SO, SO₂, NR', O, S ou CONR' et où un ou plusieurs atome(s) de H peut/peuvent être remplacé(s) par F, Cl, Br, I, CN ou NO₂, un groupe réticulable ou un système de cycle aromatique ou hétéroaromatique qui comporte de 5 à 60 atomes de cycle, lequel peut dans chaque cas être substitué par un radical ou par plusieurs radicaux R', ou un groupe aryloxy ou hétéroaryloxy qui comporte de 5 à 60 atomes de cycle, lequel peut être substitué par un radical ou par plusieurs radicaux R', ou une combinaison de ces systèmes, où deux substituants R ou plus peuvent également former un système de cycle aliphatique ou aromatique mono- ou polycyclique l'un avec l'autre ou les uns avec les autres, où R' est dans chaque cas, de manière indépendante les uns des autres, H ou un radical hydrocarbone aliphatique ou aromatique qui comporte de 1 à 20 atome(s) de C et Ar est un groupe aryle ou hétéroaryle qui comporte de 2 à 30 atomes de C.

6. Dispositif électronique selon une ou plusieurs des revendications 1 à 5, **caractérisé en ce que** le polymère contient au moins une unité structurelle de connexion.

7. Dispositif électronique selon la revendication 6, **caractérisé en ce que** le polymère contient au moins une unité structurelle de connexion de la formule (IV) 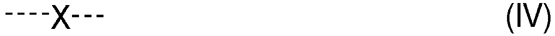 dans laquelle X est un groupe d'espaceur et les lignes en pointillés représentent la liaison dans le polymère.

8. Dispositif électronique selon la revendication 6, **caractérisé en ce que** le polymère contient au moins une unité structurelle de connexion de la formule (Va) 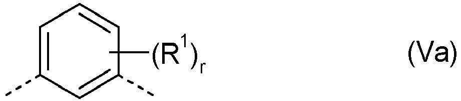 dans laquelle
R¹ est un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C ou est un groupe silyle ou un groupe céto substitué qui comporte de 1 à 40 atome(s) de C, un groupe alcoxycarbonyle qui comporte de 2 à 40 atomes de C, un groupe aryloxy-carbonyle qui comporte de 7 à 40 atomes de C, un groupe cyano (-CN), un groupe carbamoyle (-C(=O)NH₂), un groupe halo-formyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe amino, un groupe hydroxyle, un groupe nitro, un groupe CF₃, Cl, Br, F, un groupe réticulable ou un système de cycle aromatique ou hétéroaromatique substitué ou non substitué qui comporte de 5 à 60 atomes de cycle, ou un groupe aryloxy ou hétéroaryloxy qui comporte de 5 à 60 atomes de cycle, ou une combinaison de ces systèmes, où un ou plusieurs des groupes R¹ peut/peuvent former un système de cycle aliphatique ou aromatique mono- ou polycyclique les uns avec les autres et/ou avec le cycle auquel le groupe R¹ est lié ;
r est 0, 1, 2, 3 ou 4 et
les lignes en pointillés représentent la liaison dans le polymère.

9. Dispositif électronique selon la revendication 6, **caractérisé en ce que** le polymère contient au moins une unité structurelle de connexion de la formule (Vb) 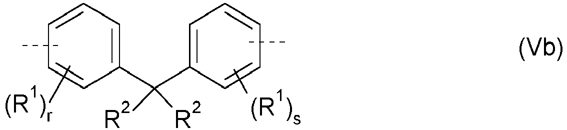 dans laquelle
R¹, R² sont dans chaque cas, de manière indépendante les uns des autres, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C ou sont un groupe silyle ou un groupe céto substitué qui comporte de 1 à 40 atome(s) de C, un groupe alcoxycarbonyle qui comporte de 2 à 40 atomes de C, un groupe aryloxy-carbonyle qui comporte de 7 à 40 atomes de C, un groupe cyano (-CN), un groupe carbamoyle (-C(=O)NH₂), un groupe haloformyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe amino, un groupe hydroxyle, un groupe nitro, un groupe CF₃, Cl, Br, F, un groupe réticulable ou un système de cycle aromatique ou hétéroaromatique substitué ou non substitué qui comporte de 5 à 60 atomes de cycle, ou un groupe aryloxy ou hétéroaryloxy qui comporte de 5 à 60 atomes de cycle, ou une combinaison de ces systèmes, un ou plusieurs des groupes R¹ et/ou R² peut/peuvent former un système de cycle aliphatique ou aromatique mono- ou polycyclique les uns avec les autres et/ou avec le cycle auquel le groupe R¹ est lié ;
r, s sont, de manière indépendante l'un de l'autre, 0, 1, 2, 3 ou 4 et
les lignes en pointillés représentent la liaison dans le polymère.

10. Dispositif électronique selon la revendication 9, **caractérisé en ce que** le polymère contient au moins une unité structurelle de connexion de la formule (Vb1) 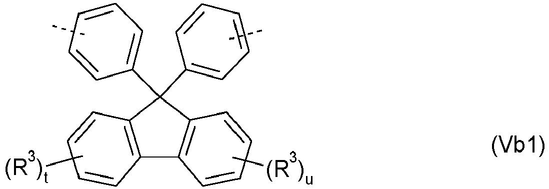 dans laquelle
R³ est dans chaque cas, de manière indépendante les uns des autres, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C ou est un groupe silyle ou un groupe céto substitué qui comporte de 1 à 40 atome(s) de C, un groupe alcoxycarbonyle qui comporte de 2 à 40 atomes de C, un groupe aryloxycarbonyle qui comporte de 7 à 40 atomes de C, un groupe cyano (-CN), un groupe carbamoyle (-C(=O)NH₂), un groupe halo-formyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe amino, un groupe hydroxyle, un groupe nitro, un groupe CF₃, Cl, Br, F, un groupe réticulable ou un système de cycle aromatique ou hétéroaromatique substitué ou non substitué qui comporte de 5 à 60 atomes de cycle, ou un groupe aryloxy ou hétéroaryloxy qui comporte de 5 à 60 atomes de cycle, ou une combinaison de ces systèmes, où un ou plusieurs des groupes R³ peut/peuvent former un système de cycle aliphatique ou aromatique mono- ou polycyclique les uns avec les autres et/ou avec le cycle auquel le groupe R³ est lié ;
t, u sont, de manière indépendante l'un de l'autre, 0, 1, 2, 3 ou 4 et les lignes en pointillés représentent la liaison dans le polymère.

11. Dispositif électronique selon la revendication 10, **caractérisé en ce que** le polymère contient au moins une unité structurelle de connexion de la formule (Vb2) 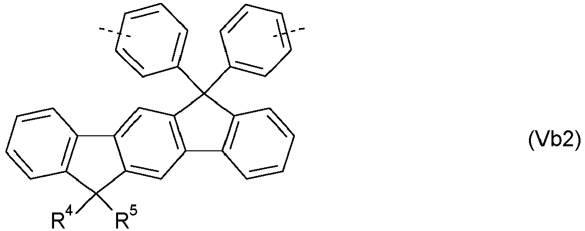 dans laquelle
R⁴, R⁵ sont dans chaque cas, de manière indépendante l'un de l'autre, un groupe alkyle, alcoxy ou thioalcoxy en chaîne droite qui comporte de 1 à 40 atome(s) de C ou un groupe alkyle, alcoxy ou thioalcoxy ramifié ou cyclique qui comporte de 3 à 40 atomes de C ou sont un groupe silyle ou un groupe céto substitué qui comporte de 1 à 40 atome(s) de C, un groupe alcoxycarbonyle qui comporte de 2 à 40 atomes de C, un groupe aryloxy-carbonyle qui comporte de 7 à 40 atomes de C, un groupe cyano (-CN), un groupe carbamoyle (-C(=O)NH₂), un groupe halo-formyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe amino, un groupe hydroxyle, un groupe nitro, un groupe CF₃, Cl, Br, F, un groupe réticulable ou un système de cycle aromatique ou hétéroaromatique substitué ou non substitué qui comporte de 5 à 60 atomes de cycle, ou un groupe aryloxy ou hétéroaryloxy qui comporte de 5 à 60 atomes de cycle, ou une combinaison de ces systèmes, où un ou plusieurs des groupes R⁴, R⁵ peut/peuvent former un système de cycle aliphatique ou aromatique mono- ou polycyclique les uns avec les autres et/ou avec le cycle auquel le groupe R⁴ ou R⁵ est lié, et
les lignes en pointillés représentent la liaison dans le polymère.

12. Dispositif électronique selon une ou plusieurs des revendications 1 à 11, **caractérisé en ce qu'**il s'agit d'un dispositif électroluminescent organique (OLED), d'un dispositif électroluminescent polymérique (PLED), d'un circuit intégré organique (O-IC), d'un transistor à effet de champ organique (O-FET), d'un transistor à film mince organique (O-TFT), d'un transistor à émission de lumière ou électroluminescent organique (O-LET), d'une cellule solaire organique (O-SC), d'un détecteur optique organique, d'un photorécepteur organique, d'un dispositif à extinction de champ organique (O-FQD), d'une cellule électrochimique à émission de lumière ou électroluminescente (LEC) ou d'une diode laser organique (O-laser).
